# FASCICULE DE BREVET EUROPEEN

(11) **EP 4 188 061 B1**
(45) Date de publication et mention de la délivrance du brevet: **09.09.2026**
(21) Numéro de dépôt: 22209799.0
(22) Date de dépôt: 28.11.2022
(51) Int. Cl.: H10N 60/01, H10N 69/00, H10W 70/63, H10W 70/65, H10W 70/66, H10W 70/698, G06N 10/40

(54) **STRUCTURE D'INTÉGRATION DESTINÉE À CONNECTER UNE PLURALITÉ DE DISPOSITIFS SEMI-CONDUCTEURS, PROCÉDÉS, ASSEMBLAGE ET SYSTÈME ASSOCIÉS**
INTEGRATIONSSTRUKTUR ZUR VERBINDUNG MEHRERER HALBLEITERBAUELEMENTE, VERFAHREN, ANORDNUNG UND SYSTEM DAFÜR
INTEGRATION STRUCTURE FOR CONNECTING A PLURALITY OF SEMICONDUCTOR DEVICES, METHODS, ASSEMBLY AND SYSTEM THEREOF

(30) Priorité: 30.11.2021 FR 2112738
(43) Date de publication de la demande: 31.05.2023
(73) Titulaire: Commissariat à l'Energie Atomique et aux Energies Alternatives, 75015 Paris (FR)
(72) Inventeur: CHARBONNIER, Jean, 38054 GRENOBLE CEDEX 09 (FR); DESCHASEAUX, Edouard, 38054 GRENOBLE CEDEX 09 (FR); THOMAS, Candice, 38054 GRENOBLE CEDEX 09 (FR)
(74) Mandataire: Cabinet Camus Lebkiri

(56) Documents cités:
- EP-A1- 3 971 983
- WO-A1-2017/015432
- US-A1- 2018 013 052
- DONNA-RUTH W YOST ET AL: "Solid-state qubits integrated with superconducting through-silicon vias", ARXIV.ORG, CORNELL UNIVERSITY LIBRARY, 201 OLIN LIBRARY CORNELL UNIVERSITY ITHACA, NY 14853, 29 September 2020 (2020-09-29), XP081773175, DOI: 10.1038/S41534-020-00289-8

## Description

### DOMAINE TECHNIQUE DE L'INVENTION

Le domaine technique de l'invention est celui des micro et nano systèmes et de leur assemblage dans le cadre de l'informatique quantique.

La présente invention concerne une structure d'intégration destinée à accueillir des puces de contrôle et des puces fonctionnelles et en particulier une structure d'intégration comprenant un routage bifonctionnel : thermique et électrique.

### ARRIERE-PLAN TECHNOLOGIQUE DE L'INVENTION

Pour les applications relatives à l'informatique quantique, les micro ou nano systèmes fonctionnent généralement à des très basses températures (de l'ordre de quelques Kelvin (K) voire quelques mK) qui sont obtenues grâce à des cryostats à dilution. La gestion thermique des éléments qui composent ces systèmes ou bien encore leur packaging diffère complétement de ce qui se fait à température ambiante, c'est-à-dire aux alentours de 300 K. En effet, la contribution des phonons à la conduction thermique s'atténuant en T³ où T est la température considérée, la thermalisation à ces très basses températures se fait majoritairement par la conductivité thermique électronique. De manière générale, les structures d'intégration de l'état de la technique ne tirent pas avantage de cette particularité afin d'isoler thermiquement les différents éléments d'un assemblage.

Par exemple, dans le document US2019/0273197 A1, les différentes puces de l'assemblage sont connectées entre elles aux moyens de pistes conductrices de sorte qu'il existe un couplage thermique entre les différentes puces. Ce couplage thermique peut être particulièrement problématique lorsqu'une ou plusieurs puces sont sensibles à l'échauffement. Un autre exemple est donné dans le document WO2018/052399 A1 dans lequel la connexion entre les puces et la structure d'intégration peut se faire au travers d'une bille (ou bump en anglais) de connexion supraconductrice. Si une telle configuration permet effectivement d'isoler thermiquement les puces entres-elles, les puces se retrouvent également isolées du cryostat ce qui ne permet pas une bonne thermalisation de ces dernières. Les documents US2018/013052A1 et WO2017015432 décrivent chacun une structure supraconductrice à faible perte de type flip-chip qui comprend un module supraconducteur à plusieurs puces comportant un chemin de signal supraconducteur disposé à travers celui-ci. Le document EP397982 décrit une structure d'intégration destinée à être connectée à un ou plusieurs dispositifs semi-conducteurs.

Il existe donc un besoin d'une structure d'intégration qui permette une bonne thermalisation des puces tout en assurant une bonne isolation thermique des puces entres-elles.

### RESUME DE L'INVENTION

L'invention offre une solution aux problèmes évoqués précédemment, en proposant une structure d'intégration avec un routage bifonctionnel en trois dimensions (c'est-à-dire dans le plan de chaque surface de la structure d'intégration mais également hors de ces plans) : certaines pistes de routage et certains vias assurant une fonction thermique et électrique (les pistes de routage conductrices et les vias conducteurs) et certaines pistes et certains vias n'assurant qu'une fonction électrique (les pistes de routage supraconductrices et les vias supraconducteurs). On entend par « fonction thermique » le fait de permettre une thermalisation ou garantir un maintien de la température cryogénique ciblée de l'objet à thermaliser. On entend par « fonction électrique » le fait de transmettre des signaux électriques entre les différents éléments de la structure d'intégration.

Un premier aspect de l'invention concerne une structure d'intégration destinée à connecter une pluralité de dispositifs semi-conducteurs telle que définie dans la revendication 1.

On entend par « le ou les niveaux de routage comprenant » que lorsqu'un seul niveau de routage est présent, il comprend au moins une première piste de routage conductrice et au moins une première piste de routage supraconductrice ; mais lorsque plusieurs niveaux de routage sont présents, la première piste de routage conductrice peut se trouver sur un premier niveau de routage tandis que la première piste de routage supraconductrice peut se trouver sur un deuxième niveau de routage.

Grâce à l'invention, il devient possible de réaliser des assemblages multipuces en trois dimensions avec un routage bifonctionnel. Ce routage bifonctionnel permet de mettre en place une isolation thermique entre les différentes puces connectées à la structure d'intégration, la communication électrique entre puces pouvant se faire par l'intermédiaire des pistes de routage supraconductrices et/ou des vias supraconducteur et la thermalisation pouvant se faire par l'intermédiaire des pistes de routage conductrices et/ou des vias conducteurs, par exemple pour créer des cages thermiques individuelles au niveau de chaque puce de sorte à les isoler thermiquement les unes des autres.

De plus, s'agissant d'un routage bifonctionnel en trois dimensions, la structure d'intégration peut servir à isoler thermiquement un dispositif situé sur sa première face d'un dispositif situé sur sa deuxième face. Plus généralement, le routage bifonctionnel en trois dimensions permet une mise en place plus compacte des dispositifs semi-conducteurs, la troisième dimension (perpendiculaire à la surface de la structure d'intégration) étant également utilisée.

Outre les caractéristiques qui viennent d'être évoquées dans le paragraphe précédent, la structure d'intégration selon un premier aspect de l'invention peut présenter une ou plusieurs caractéristiques complémentaires parmi les suivantes, considérées individuellement ou selon toutes les combinaisons techniquement possibles.

Dans un mode de réalisation, la structure d'intégration comprend une pluralité de niveaux de routage au niveau de la première face et/ou de la deuxième face, les niveaux de routage de la pluralité de niveaux de routage étant connectés, entre pistes de routage de même type, au moyen de vias inter-niveaux de même type.

Dans un mode de réalisation, le niveau de routage le plus proche de la première surface et/ou de la deuxième surface ne comprend qu'une ou plusieurs pistes de routage supraconductrices.

Dans un mode de réalisation, la structure d'intégration comprend, sur la première face et/ou sur la deuxième face, au moins un composant passif, de préférence une pluralité de composants passifs (par exemple une ou plusieurs inductances, et/ou une ou plusieurs capacités, et/ou une ou plusieurs résistances, et/ou un ou plusieurs résonateurs), lesdits composants étant de préférence réalisés à l'aide des pistes de routage conductrices non supraconductrices et/ou supraconductrices associées à la face considérée.

Un deuxième aspect de l'invention concerne un procédé de fabrication d'une structure d'intégration tel que défini dans la revendication 5.

Outre les caractéristiques qui viennent d'être évoquées dans le paragraphe précédent, le procédé selon un deuxième aspect de l'invention peut présenter une ou plusieurs caractéristiques complémentaires parmi les suivantes, considérées individuellement ou selon toutes les combinaisons techniquement possibles.

Dans un mode de réalisation, le procédé comprend, après l'étape de formation d'au moins un niveau de routage au niveau de la première face :
- une étape de formation, au niveau de la première face, de métallisations sous billes conductrices au niveau d'une partie au moins des pistes conductrices et de métallisations sous bille supraconductrices au niveau d'une partie au moins des pistes supraconductrices ;
- une étape de formation de billes d'un type choisi parmi les billes supraconductrices et les billes conductrices non supraconductrices, les billes d'un type donné étant formée au niveau des métallisation sous billes du même type au niveau de la première face ;

Dans un mode de réalisation, le procédé comprend, après l'étape de formation d'au moins un niveau de routage au niveau de la deuxième face :
- une étape de formation, au niveau de la deuxième face, de métallisations sous billes conductrices au niveau d'une partie au moins des pistes conductrices et de métallisations sous billes supraconductrices au niveau d'une partie au moins des pistes supraconductrices ;
- une étape de formation de billes d'un type choisi parmi les billes supraconductrices et les billes conductrices non supraconductrices, les billes d'un type donné étant formées au niveau des métallisations sous billes du même type au niveau de la deuxième face.

Dans un mode de réalisation alternatif, le procédé comprend, après l'étape de formation d'au moins un niveau de routage de la première face :
- Une étape de formation, au niveau de la première face, de plots conducteurs non supraconducteurs au niveau d'une partie au moins des pistes conductrices non supraconductrices, chaque plot conducteur non supraconducteur comprenant de préférence une couche conductrice en contact avec une piste conductrice non supraconductrice et une couche supraconductrice sur la couche conductrice ;
- Une étape de formation, au niveau de la première face, de plots supraconducteurs au niveau d'une partie au moins des pistes supraconductrices, chaque plot supraconducteur comprenant de préférence une couche supraconductrice.

Dans un mode de réalisation alternatif, le procédé comprend, après l'étape de formation d'au moins un niveau de routage au niveau de la deuxième face :
- une étape de formation, au niveau de la deuxième face, de plots conducteurs non supraconducteurs au niveau d'une partie au moins des pistes conductrices non supraconductrices, chaque plot conducteur non supraconducteur comprenant de préférence une couche conductrice en contact avec une piste conductrice non supraconductrice et une couche supraconductrice sur la couche conductrice ;
- une étape de formation, au niveau de la deuxième face, de plots supraconducteurs au niveau d'une partie au moins des pistes supraconductrices, chaque plot supraconducteur comprenant de préférence une couche supraconductrice.

Dans un mode de réalisation, l'étape de formation, dans le substrat, d'au moins un via non traversant conducteur non supraconducteur et d'au moins un via non traversant supraconducteur comprend :
- une étape de formation, dans le substrat, d'au moins un via non traversant conducteur non supraconducteur, le ou les vias comprenant une extrémité exposée au niveau de la première face ;
- une étape de formation, dans le substrat, d'au moins un via non traversant supraconducteur, le ou les vias comprenant une extrémité exposée au niveau de la première face.

Dans un mode de réalisation alternatif, lors de l'étape de formation d'au moins un via non traversant conducteur non supraconducteur et d'au moins un via non traversant supraconducteur, les deux types de vias sont formés simultanément.

Un troisième aspect de l'invention concerne un procédé de fabrication d'une structure d'intégration à partir d'un substrat comprenant une première face et une deuxième face et comprenant :
- une étape de formation, dans le substrat, d'au moins un via non traversant supraconducteur ou d'au moins un via non traversant conducteur non supraconducteur, le ou les vias comprenant une extrémité exposée au niveau de la première face ;
- une étape de formation d'au moins un niveau de routage au niveau de la première face, le niveau de routage comprenant au moins une piste conductrice non supraconductrice reliée à un via conducteur lorsqu'un tel via a été formé lors de l'étape précédente et au moins une piste supraconductrice reliée à un via supraconducteur lorsqu'un tel via a été formé lors de l'étape précédente ;
- une étape de collage temporaire du substrat à une poignée de manipulation au niveau de sa première face ;
- une étape d'amincissement du substrat au niveau de sa deuxième face de sorte à exposer les vias traversants conducteurs non supraconducteurs ou les vias traversants supraconducteurs formés lors de la première étape ;
- une étape de formation, dans le substrat au niveau de la deuxième face, d'au moins un via traversant conducteur non supraconducteur si au moins un via supraconducteur a été formé précédemment ou au moins un via traversant supraconducteur si au moins un via conducteur non supraconducteur a été formé précédemment, le ou les vias comprenant une extrémité au niveau de la première face en contact avec au moins une piste du même type de cette première face, et une extrémité exposée au niveau de la deuxième face ;
- une étape de formation d'au moins un niveau de routage au niveau de la deuxième face, le niveau de routage comprenant au moins une piste conductrice non supraconductrice reliée à un via conducteur non supraconducteur et au moins une piste supraconductrice reliée à un via supraconducteur ;
- une étape de retrait de la poignée de manipulation.

Outre les caractéristiques qui viennent d'être évoquées dans le paragraphe précédent, le procédé selon un troisième aspect de l'invention peut présenter une ou plusieurs caractéristiques complémentaires parmi les suivantes, considérées individuellement ou selon toutes les combinaisons techniquement possibles.

Dans un mode de réalisation, le procédé comprend, après l'étape de formation d'au moins un niveau de routage au niveau de la première face :
- une étape de formation, au niveau de la première surface, de métallisations sous billes conductrices au niveau d'une partie au moins des pistes conductrices et de métallisations sous billes supraconductrices au niveau d'une partie au moins des pistes supraconductrices ;
- une étape de formation de billes d'un type choisi parmi les billes supraconductrices et les billes conductrices non supraconductrices, les billes d'un type donné étant formées au niveau des métallisations sous billes du même type au niveau de la première face.

Dans un mode de réalisation, le procédé comprend, après l'étape de formation d'au moins un niveau de routage au niveau de la deuxième face :
- une étape de formation, au niveau de la deuxième face, de métallisations sous billes conductrices au niveau d'une partie au moins des pistes conductrices et de métallisations sous billes supraconductrices au niveau d'une partie au moins des pistes supraconductrices ;
- une étape de formation de billes d'un type choisi parmi les billes supraconductrices et les billes conductrices non supraconductrices, les billes d'un type donné étant formées au niveau des métallisations sous billes du même type au niveau de la deuxième face.

Dans un mode de réalisation alternatif, le procédé comprend, après l'étape de formation d'au moins un niveau de routage de la première face :
- Une étape de formation, au niveau de la première face, de plots conducteurs non supraconducteurs au niveau d'une partie au moins des pistes conductrices non supraconductrices, chaque plot conducteur non supraconducteur comprenant de préférence une couche conductrice en contact avec une piste conductrice non supraconductrice et une couche supraconductrice sur la couche conductrice ;
- Une étape de formation, au niveau de la première face, de plots supraconducteurs au niveau d'une partie au moins des pistes supraconductrices, chaque plot supraconducteur comprenant de préférence une couche supraconductrice.

Dans un mode de réalisation alternatif, le procédé comprend, après l'étape de formation d'au moins un niveau de routage au niveau de la deuxième face :
- une étape de formation, au niveau de la deuxième face, de plots conducteurs non supraconducteurs au niveau d'une partie au moins des pistes conductrices non supraconductrices, chaque plot conducteur non supraconducteur comprenant de préférence une couche conductrice en contact avec une piste conductrice non supraconductrice et une couche supraconductrice sur la couche conductrice ;
- une étape de formation, au niveau de la deuxième face, de plots supraconducteurs au niveau d'une partie au moins des pistes supraconductrices, chaque plot supraconducteur comprenant de préférence une couche supraconductrice.

Un quatrième aspect de l'invention concerne un assemblage comprenant une structure d'intégration selon un premier aspect de l'invention, un premier dispositif semi-conducteur, dit puce fonctionnelle et un deuxième dispositif semi-conducteur, dit puce de contrôle, la puce fonctionnelle étant connectée à la structure d'intégration au niveau de la première face et la puce de contrôle étant connectée à la structure d'intégration au niveau de la deuxième face.

Un cinquième aspect de l'invention concerne un système comprenant un support de packaging et un assemblage, selon la revendication précédente, connectés électriquement entre eux.

Outre les caractéristiques qui viennent d'être évoquées dans le paragraphe précédent, le système selon un cinquième aspect de l'invention peut présenter une ou plusieurs caractéristiques complémentaires parmi les suivantes, considérées individuellement ou selon toutes les combinaisons techniquement possibles.

Dans un mode de réalisation, la puce de contrôle comprend une première face et une deuxième face et l'assemblage est connecté thermiquement au support de packaging par l'intermédiaire de la deuxième face de la puce de contrôle, ladite puce de contrôle étant connectée électriquement par sa première face à la deuxième face de la structure d'intégration, de préférence via des billes.

Dans un mode de réalisation, l'assemblage est connecté électriquement au support de packaging par l'intermédiaire de la deuxième face de la structure d'intégration, de préférence via des billes.

Dans un mode de réalisation, la structure d'intégration SI comportent des composant passifs comprenant une inductance et/ou une capacité et/ou une résonateur et/ou une résistance, ladite inductance et/ou ladite capacitance et/ou ledit résonateur étant connectés électriquement, à l'aide d'une ou plusieurs pistes de routage, de préférence des pistes de routage supraconductrices, à la puce de contrôle et/ou à la puce fonctionnelle, et ladite résistance étant connectée par une liaison conductrice non supraconductrice au support de packaging.

L'invention et ses différentes applications seront mieux comprises à la lecture de la description qui suit et à l'examen des figures qui l'accompagnent.

### BREVE DESCRIPTION DES FIGURES

Les figures sont présentées à titre indicatif et nullement limitatif de l'invention.
Les [Fig. 1] et [Fig. 2] montrent une représentation schématique d'une structure d'intégration selon deux modes de réalisation différents de l'invention.
Les [Fig. 3A] à [Fig. 3P] montrent une représentation schématique d'un procédé selon un deuxième aspect de l'invention.
Les [Fig. 4A] à [Fig. 4P] montrent une représentation schématique d'un procédé selon un troisième aspect de l'invention.
Les [Fig. 5A] et [Fig. 5B] montrent une variante de réalisation d'un procédé selon un deuxième aspect de l'invention.
Les [Fig. 6A] à [Fig. 6C] montrent une représentation schématique de trois modes de réalisation différents d'un assemblage et d'un système selon l'invention.

### DESCRIPTION DETAILLEE

Les figures sont présentées à titre indicatif et nullement limitatif de l'invention. Sauf précision contraire, un même élément apparaissant sur des figures différentes présente une référence unique.

Dans la suite, le terme « conducteur non supraconducteur » sera utilisé pour insister sur le fait qu'un élément est conducteur mais pas supraconducteur. Cependant, dans la présente description, le terme « conducteur » est à comprendre comme « conducteur non supraconducteur », même lorsque le terme « non supraconducteur » est absent. De préférence, un matériau est considéré comme supraconducteur lorsque sa température critique est supérieure à 2K, voire supérieure à 4K.

### Structure d'intégration

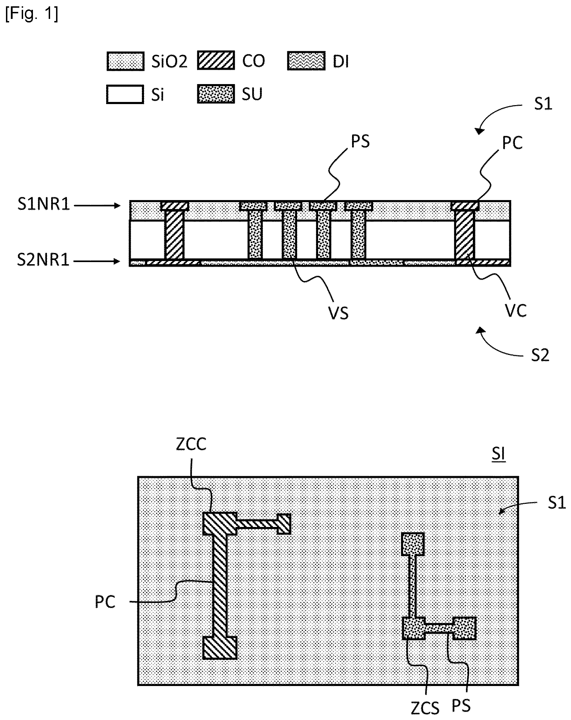

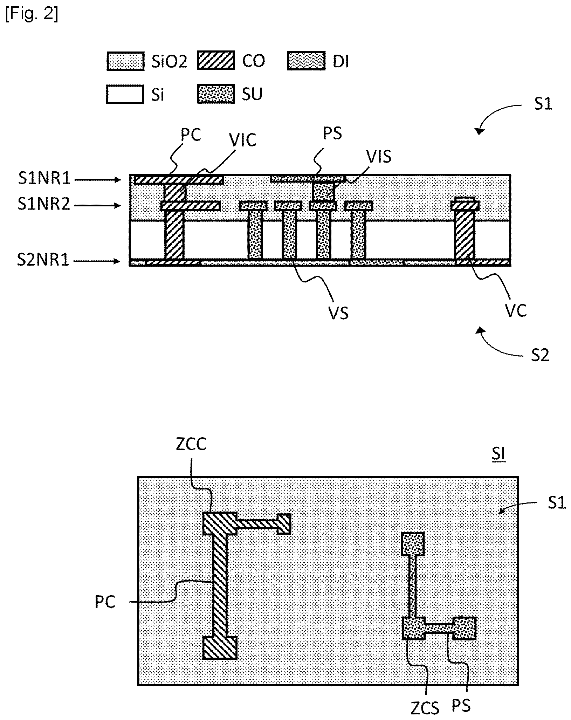

Un premier aspect de l'invention illustré à la [Fig. 1] et à la [Fig. 2] concerne une structure SI d'intégration destinée à connecter une pluralité de dispositifs semi-conducteurs DS, la structure d'intégration SI comprenant un substrat SB, une première face S1 et une deuxième face S2 destinées à recevoir les dispositifs semi-conducteurs DS. Dans la structure SI de la [Fig. 1] et de la [Fig. 2], le substrat SB est un substrat de silicium Si. Ce matériau présente l'avantage de posséder une résistance thermique élevée dans la gamme de températures cryogéniques utilisée pour le fonctionnement des puces fonctionnelles et fournit donc une bonne isolation thermique. C'est particulièrement avantageux dans le cadre d'un assemblage selon l'invention (décrit plus loin) afin d'isoler thermiquement un premier dispositif semi-conducteur situé sur la première face S1 d'un deuxième dispositif semi-conducteur situé sur la deuxième face S2.

La structure SI d'intégration selon l'invention comprend, au niveau de la première surface S1, au moins un niveau S1NR1 de routage, le ou les niveaux S1NR1 de routage comprenant au moins une piste de routage conductrice PC non supraconductrice dans un matériau conducteur CO ; et au moins une piste de routage supraconductrice PS dans un matériau supraconducteur SU. Dans les [Fig. 1] et [Fig. 2], ces niveaux de routage sont réalisés au sein d'une couche d'oxyde de silicium SiO₂, mais tout matériau diélectrique peut être utilisé.

De plus, la structure SI d'intégration selon l'invention comprend, au niveau de la deuxième surface S2, au moins un niveau de routage S2NR1, le ou les niveaux de routage S2NR1 comprenant au moins une piste de routage conductrice PC non supraconductrice dans un matériau conducteur CO ; et au moins une piste de routage supraconductrice PS dans un matériau supraconducteur SU. Dans les [Fig. 1] et [Fig. 2], ces niveaux de routage sont réalisés au sein d'un matériau diélectrique DI, par exemple de l'oxyde de silicium SiO₂.

Dans un mode de réalisation, une ou plusieurs pistes conductrices PC et/ou une ou plusieurs pistes supraconductrices PS situées au niveau de la première face S1 et/ou de la deuxième face S2 comportent une ou plusieurs zones de connexion ZCC/ZCS au niveau desquelles pourront être réalisées des métallisations sous billes conductrices UBMC (pour les pistes conductrices PC) et supraconductrices UBMS (pour les pistes supraconductrices PS).

Dans un mode de réalisation, lorsqu'une pluralité de niveaux de routage est présente au niveau de l'une des faces S1/S2 (ou des deux faces), un niveau de routage peut ne comporter que des pistes de routage d'un type donné (par exemple, que des pistes de routage conductrices non supraconductrices).

Dans un mode de réalisation, la structure d'intégration SI comprend, au niveau de la première face S1 (illustré à la [Fig. 2]) et/ou de la deuxième face S2 (non illustré), une pluralité de niveaux de routage, les niveaux de routage de la pluralité de niveaux de routage étant connectés, entre pistes de routage PS/PC de même type, au moyen de vias inter-niveaux VIS/VIC de même type. Sur la [Fig. 2], la structure d'intégration SI comprend, au niveau de sa première face S1, un premier niveau de routage S1NR1 et un deuxième niveau de routage S1NR2. Au moins une partie des pistes conductrices PC du premier niveau de routage S1NR1 est reliée à une ou plusieurs pistes conductrices PC du deuxième niveau de routage S1NR2 au moyen de vias inter-niveaux conducteurs VIC. De même, au moins une partie des pistes supraconductrices PS du premier niveau de routage S1NR1 est reliée à une ou plusieurs pistes supraconductrices PS du deuxième niveau de routage S1NR2 au moyen de vias inter-niveaux supraconducteurs VIS.

Enfin, la structure d'intégration SI selon l'invention comprend au moins un via conducteur VC non supraconducteur reliant une piste de routage conductrice PC non supraconductrice de la première face S1 à une piste conductrice PC non supraconductrice de la seconde face S2 et/ou au moins un via supraconducteur VS reliant une piste de routage supraconductrice PS de la première face S1 à une piste supraconductrice PS de la seconde face S2.

Ainsi, il est possible d'établir un routage bifonctionnel non seulement au niveau de l'une des faces de la structure d'intégration, mais également entre ces faces.

Dans un mode de réalisation, un via supraconducteur VS/VIS (qu'il soit traversant ou inter-niveaux) comprend un cylindre plein de nitrure de titane entouré, au niveau de sa surface latérale par une couche de titane, la couche de titane formant ainsi un cylindre creux autour dudit cylindre. Dans un mode de réalisation, la couche de titane a une épaisseur comprise entre 5 et 20 nm, et le diamètre du cylindre plein est compris entre 50 nm et 200 µm.

Dans un mode de réalisation alternatif, un via supraconducteur VS/VIS (qu'il soit traversant ou inter-niveaux) comprend un cylindre plein d'un matériau diélectrique entouré au niveau de sa surface latérale par une couche de nitrure de titane, cette dernière formant ainsi un premier cylindre creux autour du cylindre plein, le premier cylindre creux étant lui-même entouré, au niveau de sa surface latérale par une couche de titane formant un deuxième cylindre creux autour du premier cylindre creux. Dans un mode de réalisation, la couche de titane a une épaisseur comprise entre 5 et 20 nm, la couche de nitrure de titane a une épaisseur compris entre 5 et 50 nm et le diamètre du cylindre plein est compris entre 50 nm et 200 µm.

Dans un mode de réalisation encore alternatif, un via supraconducteur VS/VIS (qu'il soit traversant ou inter-niveaux) comprend un premier cylindre creux formé par une couche de nitrure de titane entouré au niveau de sa surface latérale par une couche de titane, la couche de titane formant ainsi un deuxième cylindre creux entourant le premier cylindre creux (autrement dit, le via comprend une zone de vide). Dans un mode de réalisation, la couche de titane a une épaisseur comprise entre 5 et 20 nm et la couche de nitrure de titane a une épaisseur compris entre 5 et 50 nm.

Bien entendu, dans une même structure d'intégration SI, certains des vias supraconducteurs VS peuvent être réalisés selon le premier mode tandis que les autres sont réalisés selon le second mode ou le troisième mode.

Dans un mode de réalisation, un via conducteur VC/VIC (qu'il soit traversant ou inter-niveaux) non supraconducteur comprend un cylindre plein de cuivre entouré au niveau de sa grande surface latéral par une couche de nitrure de titane, ladite couche de nitrure de titane formant ainsi un premier cylindre creux entourant le cylindre plein, le premier cylindre creux étant lui-même entouré par une couche de titane, ladite couche de titane formant ainsi un deuxième cylindre creux entourant le premier cylindre creux. Dans un mode de réalisation, la couche de titane a une épaisseur comprise entre 5 et 20 nm, la couche de nitrure de titane a une épaisseur compris entre 5 et 50 nm et le diamètre du cylindre plein est compris entre 50 nm et 200 µm. Ainsi, le diamètre du cylindre en cuivre est suffisant pour annuler, par effet de proximité, les propriétés supraconductrices du nitrure de titane.

Dans un mode de réalisation, le matériau supraconducteur utilisé pour réaliser tout ou une partie des pistes de routage supraconductrices PS et/ou les vias supraconducteurs VS est choisi parmi le nitrure de titane (TiN), le tantale (Ta), le nitrure de tantale (TaN), le niobium (Nb), le nitrure de niobium (NbN), le titane-niobium (TiNb), le germanium-niobium (Nb₃Ge) le nitrure de titane-niobium (NbTiN), l'aluminium (Al), le ruthénium (Ru) ou bien encore l'Indium (In). Bien entendu, d'autres matériaux ou alliages supraconducteurs pourront être choisis. De préférence, les matériaux choisis sont des matériaux compatibles avec les procédés de polissage mécano-chimique et/ou les procédés de gravure.

Dans un mode de réalisation, les vias traversants conducteurs VC et/ou supraconducteurs VS ont une hauteur comprise entre 5 µm et 200 µm (bornes incluses) et, lorsqu'ils sont de forme cylindrique, un diamètre compris entre 0.5 et 200 µm (bornes incluses). Dans un mode de réalisation, les vias conducteurs VC non supraconducteur et les vias supraconducteurs VS ont un diamètre de 10 µm, une hauteur de 100 µm, chaque via étant séparé du via le plus proche par une distance supérieure ou égale à 10 µm.

Dans un mode de réalisation, la structure d'intégration SI comporte des éléments passifs PASS, les éléments passifs PASS étant situés à l'extérieur de la cage thermique formée par les connexions conductrices non supraconductrices (comprenant les pistes conductrices PC et les vias conducteurs VC) de l'assemblage AS selon l'invention. Dans un mode de réalisation, les éléments passifs sont choisis parmi une inductance (de préférence supraconductrice), une capacité (de préférence supraconductrice), un résonateur (de préférence supraconductrice) et une résistance (de préférence conducteur non supraconducteur). Dans un mode de réalisation, les éléments passifs sont formés dans un ou plusieurs niveaux de routage au niveau de la première face S1 et/ou de la deuxième face S2 de la structure d'intégration SI, à l'aide d'une ou plusieurs pistes de routage, de préférence supraconductrices. De préférence, les capacités, inductances et résonateurs sont réalisés au moyen de pistes supraconductrices (PS) et les résistances au moyen de pistes conductrices (PC).

### Premier procédé de fabrication

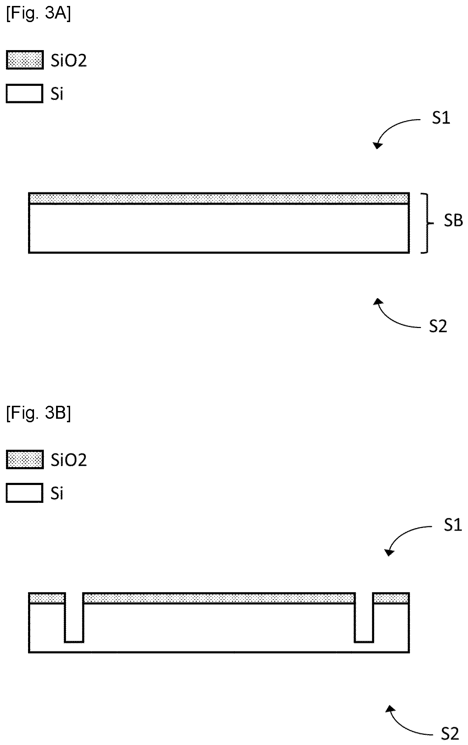

Un deuxième aspect de l'invention concerne un procédé de fabrication d'une structure d'intégration SI à partir d'un substrat comprenant une première face S1 et une deuxième face S2. Dans un mode de réalisation illustré à la [Fig. 3A], le substrat SB est un substrat de silicium Si comportant une couche d'oxyde de silicium SiO₂ au niveau de la première face S1.

### Formation d'au moins un via non traversant conducteur VC

Le procédé comprend une étape de formation, dans le substrat SB, d'au moins un via VC, de préférence une pluralité de vias, non traversant conducteur non supraconducteur, le ou les vias VC comprenant une extrémité exposée au niveau de la première face S1 (ce ou ces vias VC seront rendus traversants par la suite).

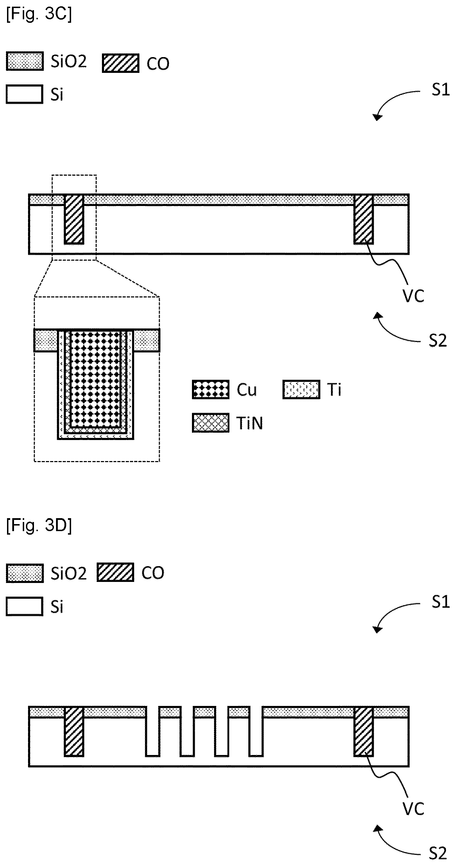

Dans un mode de réalisation illustré aux [Fig. 3B] et [Fig. 3C], cette étape comprend une sous-étape de gravure d'au moins une tranchée (de préférence une pluralité de tranchées, une tranchée pour chaque via - une tranchée peut avoir une section rectangulaire, ellipsoïdale ou ronde selon un plan parallèle à la surface du substrat SB) au niveau de la première face S1 du substrat SB et sur une partie seulement de l'épaisseur du substrat SB. Dans l'exemple de la [Fig. 3B], la totalité de l'épaisseur de la couche d'oxyde de silicium et une partie de l'épaisseur de la couche de silicium ont été gravées.

Elle comprend également une sous-étape de dépôt du ou des matériaux formant le via conducteur VC. Dans l'exemple de la [Fig. 3C], cette sous-étape comprend tout d'abord le dépôt conforme d'une couche de titane Ti (par exemple par CVD, de l'anglais Chemical Vapor Deposition ou dépôt chimique en phase vapeur en français, PVD, de l'anglais Physical Vapor Deposition ou dépôt physique en phase vapeur en français ou ALD, de l'anglais Atomic Layer Deposition ou dépôt par couche atomique en français), puis d'une couche de nitrure de titane TiN (par exemple par CVD, PVD ou ALD), suivi du dépôt d'une couche de cuivre Cu (par exemple, par un dépôt PVD suivi d'un dépôt ECD de l'anglais Electro Chemical Deposition), l'épaisseur de la couche de cuivre étant choisie de sorte à combler complètement la tranché gravée lors de la sous-étape précédente. On notera ici que l'épaisseur de cuivre étant largement supérieure à l'épaisseur de nitrure de titane ou de titane, le cuivre reste conducteur (et non supraconducteur) et assure que l'ensemble du via reste conducteur même à très basses températures. Dans un mode de réalisation, la couche de titane a une épaisseur comprise entre 5 et 20 nm, la couche de nitrure de titane a une épaisseur compris entre 5 et 50 nm et la couche de cuivre a une épaisseur comprise entre entre 50 nm et 200 µm.

### Formation d'au moins un via non traversant supraconducteur VS

Le procédé comprend également une étape de formation, dans le substrat SB, d'au moins un via non traversant supraconducteur VS, le ou les vias VS comprenant une extrémité exposée au niveau de la première face S1 (comme précédemment, ce ou ces vias VS seront rendus traversant par la suite).

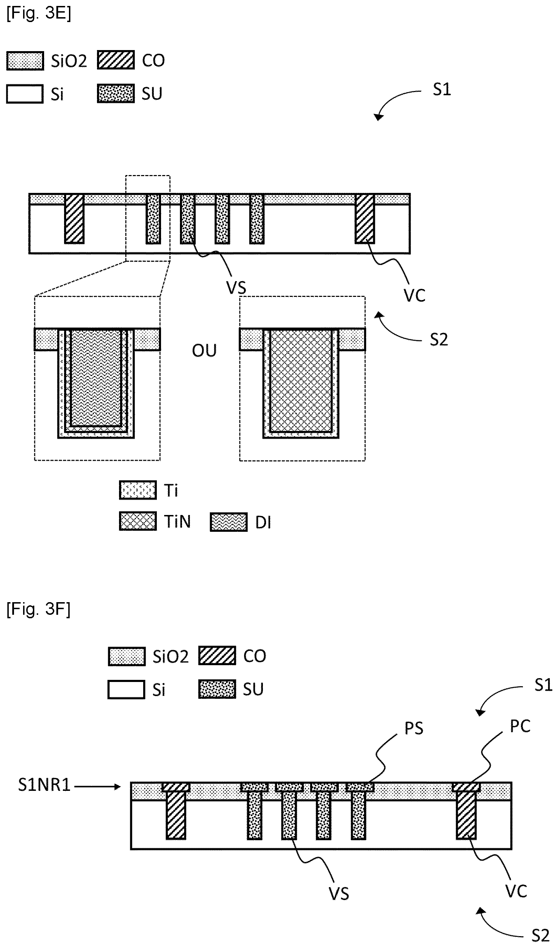

Dans un mode de réalisation illustré aux [Fig. 3D] et [Fig. 3E], cette étape comprend une sous-étape de gravure d'au moins une tranchée (de préférence une pluralité de tranchées, une tranchée pour chaque via - une tranchée peut avoir une section rectangulaire, ellipsoïdale ou ronde selon un plan parallèle à la surface du substrat SB) au niveau de la première face S1 du substrat SB et sur une partie seulement de l'épaisseur du substrat SB. Dans l'exemple de la [Fig. 3D], la totalité de l'épaisseur de la couche d'oxyde de silicium et une partie de l'épaisseur de la couche de silicium ont été gravées.

Elle comprend également une sous-étape de dépôt du ou des matériaux formant le via supraconducteur VS.

Dans l'exemple de la [Fig. 3E], dans une première variante de réalisation, cette sous-étape comprend tout d'abord le dépôt conforme d'une couche de titane (par exemple par CVD, PVD ou ALD) suivie du dépôt d'une couche de nitrure de titane (par exemple par CVD, PVD ou ALD), l'épaisseur de la couche de nitrure de titane étant choisie de sorte à combler complètement la tranchée gravée lors de la sous-étape précédente.

Dans l'exemple de la [Fig. 3E], dans une deuxième variante de réalisation, cette sous-étape comprend tout d'abord le dépôt conforme d'une couche de titane (par exemple par CVD, PVD ou ALD, de l'anglais Atomic Layer Deposition ou dépôt par couche atomique en français) puis d'une couche de nitrure de titane (par exemple par CVD, PVD ou ALD) suivi du dépôt d'une couche d'un matériau diélectrique DI, l'épaisseur de la couche de matériau diélectrique étant choisie de sorte à combler complètement la tranché gravée lors de la sous-étape précédente. Dans un mode de réalisation, la couche de titane a une épaisseur comprise entre 5 et 20 nm, la couche de nitrure de titane a une épaisseur compris entre 5 et 50 nm et la couche de diélectrique a une épaisseur comprise entre 50 nm et 200 µm.

### Formation d'au moins un niveau de routage S1NR1 au niveau de la première face S1

Comme illustré à la [Fig. 3F], le procédé comprend également une étape de formation d'au moins un niveau de routage S1NR1, de préférence une pluralité de niveaux de routage, au niveau de la première face S1, le niveau de routage S1NR1 comprenant au moins une piste conductrice PC non supraconductrice reliée à un via conducteur VC non supraconducteur et au moins une piste supraconductrice PS reliée à un via supraconducteur VS.

Plus particulièrement, si un seul niveau de routage est présent, alors ce niveau de routage comporte au moins une piste conductrice PC non supraconductrice et une piste supraconductrice PS. En revanche, si plusieurs niveaux de routage sont présents au niveau de la première face S1, alors un niveau de routage donné peut ne comporter qu'une ou plusieurs pistes conductrices PC non supraconductrices ou une ou plusieurs pistes supraconductrices PS.

### Formation des métallisations sous billes UBM sur la première face S1

Dans un mode de réalisation, le procédé comprend également une étape de formation des métallisations sous billes conductrices UBMC au niveau d'une partie au moins des pistes conductrices PC et des métallisations sous billes supraconductrices UBMS au niveau d'une partie au moins des pistes supraconductrices PS.

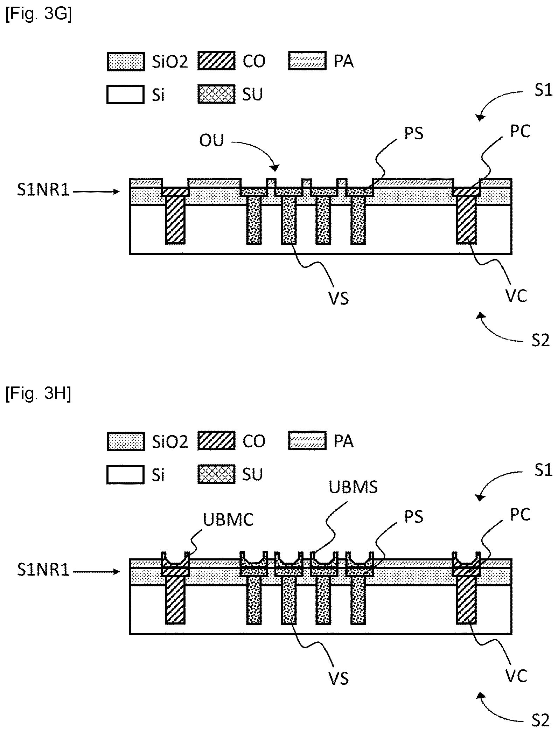

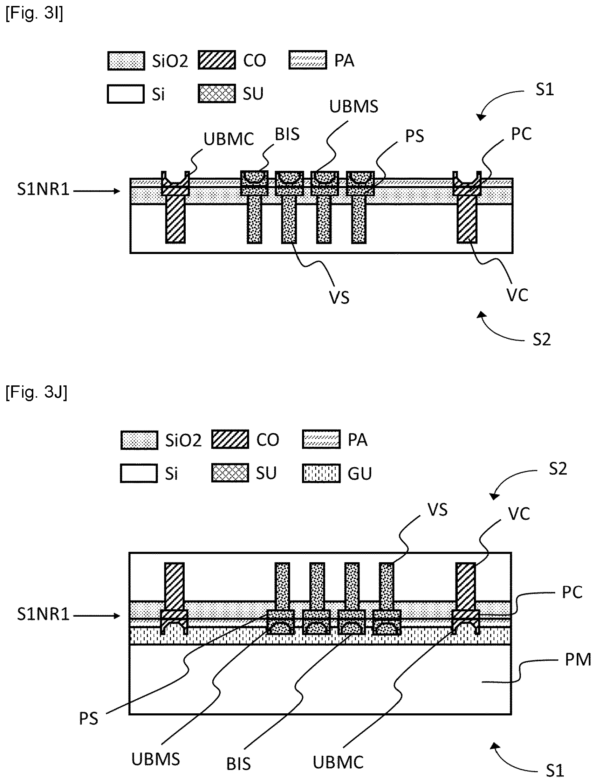

Dans un mode de réalisation illustré aux [Fig. 3G], [Fig. 3H] et [Fig. 3I], cette étape comprend tout d'abord une sous-étape de dépôt d'une couche de passivation PA suivie d'une sous-étape de gravure de la couche de passivation de sorte à former des ouvertures OU destinées à recevoir les métallisations sous billes et à les connecter aux pistes du même type. Cette étape comprend ensuite la réalisation, dans les ouvertures OU obtenues lors de la sous-étape précédente, de la ou des métallisations sous billes conductrices UBMC non supraconductrices au niveau d'une partie au moins des pistes conductrices PC non supraconductrices et de la ou des métallisations sous billes supraconductrices UBMS au niveau d'une partie au moins des pistes supraconductrices PS. Bien entendu, ces sous-étapes sont à répéter pour chaque type de métallisation sous billes, autrement dit une première fois pour les métallisations sous billes conductrices UBMC ou supraconductrices UBMS et une deuxième fois pour les métallisations sous billes supraconductrices UBMS ou conductrices UBMC.

### Formation des billes conductrices BIC ou supraconductrices BIS sur la première face S1

Dans un mode de réalisation, comme illustré à la [Fig. 3I], le procédé comprend également une étape de formation des billes d'un type choisi parmi les billes supraconductrices BIS et les billes conductrices BIC non supraconductrices, les billes BIC/BIS d'un type donné étant formées au niveau des métallisations sous billes UBMC/UBMS du même type. Autrement dit, un seul type de billes est déposé lors de cette étape. Dans l'exemple de la [Fig. 3I], seules les billes supraconductrices BIS sont déposées lors de cette étape, ces dernières BIS étant déposées au niveau des métallisations sous billes supraconductrices UBMS.

### Formation de plots pour collage direct sur la première face S1

Dans un mode de réalisation alternatif, les métallisations sous billes UBMS/UBMC et les billes conductrices BIC non supraconductrices ou les billes supraconductrices BIS au niveau de la première face S1 sont remplacées par des plots permettant une connexion par collage direct. Plus particulièrement, le procédé comprend, après l'étape de formation d'au moins un niveau de routage de la première face :
- une étape de formation, au niveau de la première face, de plots conducteurs non supraconducteurs au niveau d'une partie au moins des pistes conductrices non supraconductrices, chaque plot conducteur non supraconducteur comprenant de préférence une couche conductrice en contact avec une piste conductrice non supraconductrice et une couche supraconductrice sur la couche conductrice ;
- une étape de formation, au niveau de la première face, de plots supraconducteurs au niveau d'une partie au moins des pistes supraconductrices, chaque plot supraconducteur comprenant de préférence une couche supraconductrice.

Ainsi, dans ce mode alternatif de réalisation dans lequel un collage direct conducteur-conducteur et supraconducteur-supraconducteur (lorsque le plot conducteur non supraconducteur est réalisé dans une couche d'un matériau conducteur non supraconducteur) ou supraconducteur-supraconducteur (lorsque le plot conducteur non supraconducteur comprend une couche conductrice en contact avec une piste conductrice non supraconductrice et une couche supraconductrice sur la couche conductrice) est utilisé permettent d'envisager des schémas d'intégration forte densité avec des pas entre interconnexions inférieurs au micromètre. Cet avantage permet notamment d'envisager une intégration large échelle des qubits de spin silicium dont les dispositifs sont peu encombrants avec une surface typique de 100 nm² par qubit contre 100 µm² par qubit pour les qubits supraconducteurs par exemple.

### Collage temporaire

Comme illustré à la [Fig. 3J], le procédé comprend également une étape de collage temporaire du substrat SB à une poignée de manipulation PM au niveau de sa première face S1. Dans l'exemple de la [Fig. 3J], ce collage est réalisé à l'aide d'une couche d'adhésif GU, par exemple une colle, déposée au niveau de la première face S1 et permettant de coller le substrat SB à la poignée de manipulation PM, ici en silicium Si.

### Amincissement

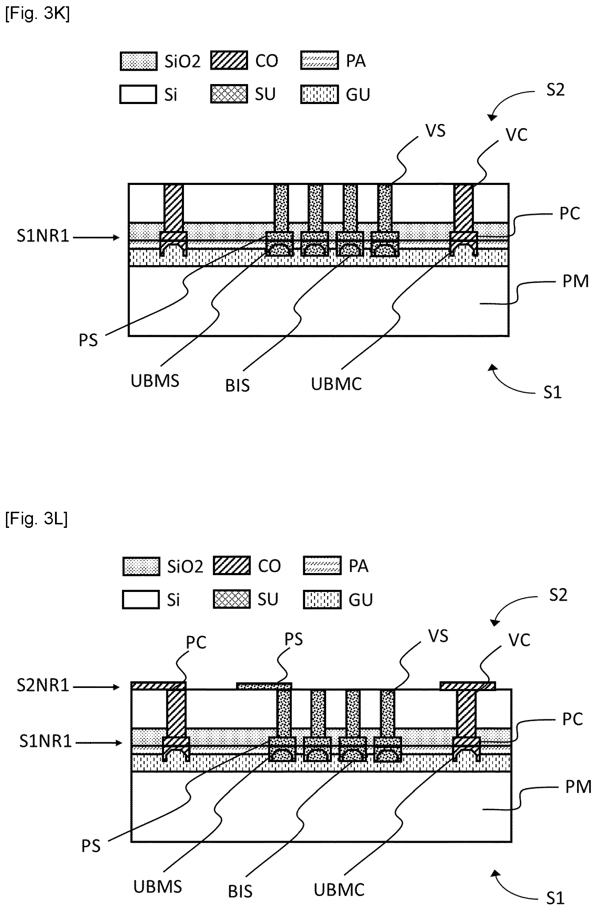

Comme illustré à la [Fig. 3K], le procédé comprend également une étape d'amincissement du substrat SB au niveau de sa deuxième face S2 de sorte à exposer les via conducteurs VC non supraconducteurs et les vias supraconducteurs VS, par exemple par polissage mécano-chimique. Ainsi exposés, les vias VC/VS peuvent ensuite être connectés à un ou plusieurs niveaux de routage.

### Formation d'au moins un niveau de routage

Comme illustré à la [Fig. 3L], le procédé comprend également une étape de formation d'au moins un niveau de routage S2NR1 au niveau de la deuxième face S2, le niveau de routage S2NR1 comprenant au moins une piste conductrice PC non supraconductrice reliée à un via conducteur VC non supraconducteur et au moins une piste supraconductrice PS reliée à un via supraconducteur VS.

Plus particulièrement, si un seul niveau de routage est présent, alors ce niveau de routage comporte au moins une piste conductrice PC non supraconductrice et une piste supraconductrice PS. En revanche, si plusieurs niveaux de routage sont présents au niveau de la deuxième face, alors un niveau de routage donné peut ne comporter qu'une ou plusieurs pistes conductrices PC non supraconductrices ou une ou plusieurs pistes supraconductrices PS.

### Formation des métallisations sous billes sur la deuxième face

Dans un mode de réalisation, le procédé comprend ensuite une étape de formation, au niveau de la deuxième face S2, des métallisations sous billes conductrices UBMC au niveau d'une partie au moins des pistes conductrices PC et des métallisations sous billes supraconductrices UBMS au niveau d'une partie au moins des pistes supraconductrices PS.

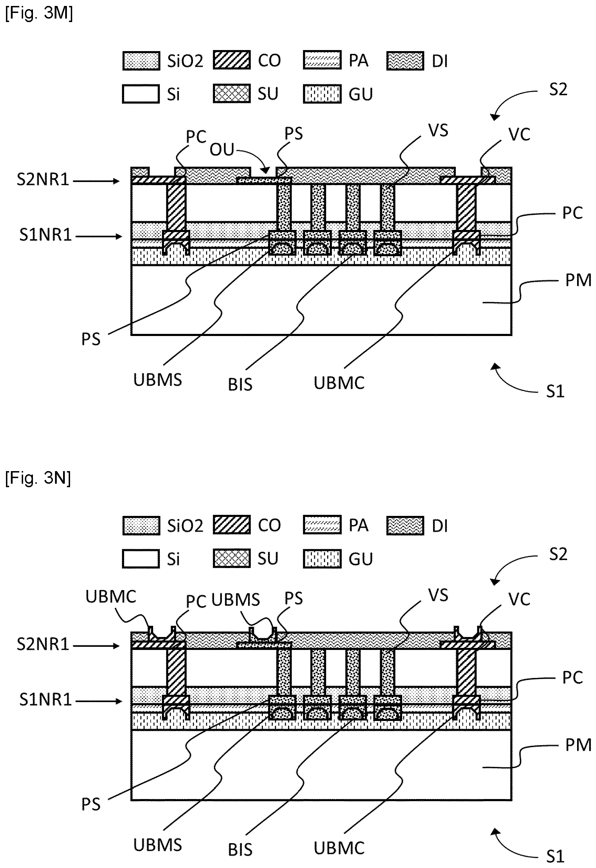

Dans un mode de réalisation illustré aux [Fig. 3M] et [Fig. 3N], cette étape comprend une sous-étape de dépôt d'une couche d'un matériau diélectrique DI, suivie d'une sous-étape de gravure de ladite couche de sorte à aménager des ouvertures OU destinées à recevoir les métallisations sous billes UBMS/UBMC et à les connecter aux pistes de même type. Cette étape comprend ensuite une sous-étape de formation, dans les ouvertures OU obtenues lors de la sous-étape précédente, de la ou des métallisations sous billes conductrices UBMC non supraconductrices au niveau d'une partie au moins des pistes conductrices PC non supraconductrices et de la ou des métallisations sous billes supraconductrices UBMS au niveau d'une partie au moins des pistes de routage supraconductrices PS. Bien entendu, ces sous-étapes sont à répéter pour chaque type de métallisations sous billes, autrement dit une première fois pour les métallisations sous billes conductrices UBMC ou supraconductrices UBMS et une deuxième fois pour les métallisations sous billes supraconductrices UBMS ou conductrices UBMC.

### Formation des billes conductrices ou supraconductrices sur la deuxième face

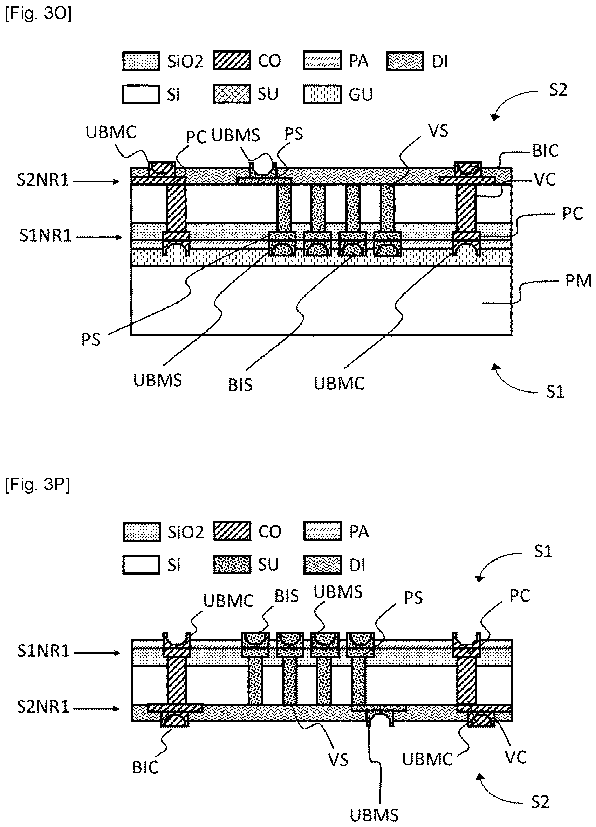

Dans un mode de réalisation, comme illustré à la figure [Fig. 3O], le procédé comprend également une étape de formation des billes d'un type choisi parmi les billes supraconductrices BIS et les billes conductrices BIC non supraconductrices, les billes d'un type donné étant formées au niveau des métallisations sous billes UBMS/UBMC du même type au niveau de la deuxième face S2.

Dans l'exemple de la [Fig. 3O], seules les billes conductrices BIC non supraconductrices sont déposées lors de cette étape, ces dernières étant déposées au niveau des métallisations sous billes conductrices UBMC non supraconductrices.

### Formation de plots pour collage direct sur la deuxième face S2

Dans un mode de réalisation alternatif, les métallisations sous billes UBMS/UBMC et les billes conductrices BIC non supraconductrices ou les billes supraconductrices BIS au niveau de la deuxième face S2 sont remplacés par des plots permettant une connexion par collage direct. Plus particulièrement, le procédé comprend, après l'étape de formation d'au moins un niveau de routage au niveau de la deuxième face :
- une étape de formation, au niveau de la deuxième face, de plots conducteurs non supraconducteurs au niveau d'une partie au moins des pistes conductrices non supraconductrices, chaque plot conducteur non supraconducteur comprenant de préférence une couche conductrice en contact avec une piste conductrice non supraconductrice et une couche supraconductrice sur la couche conductrice ;
- une étape de formation, au niveau de la deuxième face, de plots supraconducteurs au niveau d'une partie au moins des pistes supraconductrices, chaque plot supraconducteur comprenant de préférence une couche supraconductrice.

Les avantages techniques de cette solution ont déjà été détaillés précédemment et ne sont donc pas répétés ici.

### Retrait de la poignée de manipulation PM

Comme illustré à la [Fig. 3P], le procédé comprend enfin une étape de retrait de la poignée de manipulation PM.

### Résultat

A l'issue du procédé, une structure d'intégration SI selon le premier aspect de l'invention est obtenue.

### Deuxième procédé de fabrication

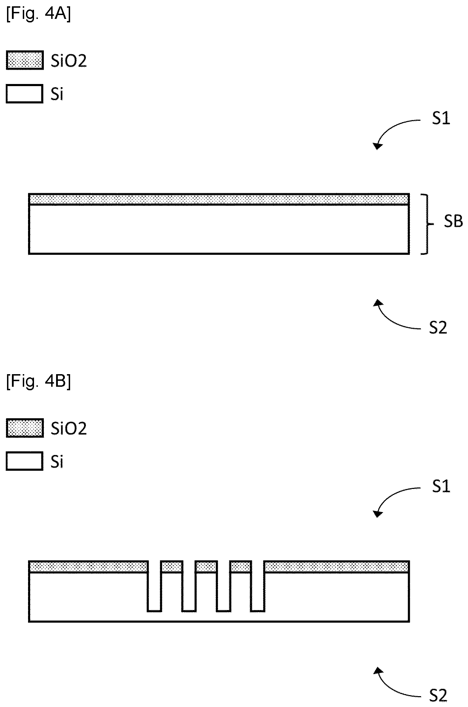

Un troisième aspect de l'invention concerne un procédé de fabrication d'une structure d'intégration SI à partir d'un substrat SB comprenant une première face S1 et une deuxième face S2. Dans un mode de réalisation illustré à la [Fig. 4A], le substrat SB est un substrat de silicium Si comportant une couche d'oxyde de silicium SiO₂ au niveau de la première face S1.

### Formation d'au moins un via non traversant supraconducteur VS ou d'au moins un via non traversant conducteur VC au niveau de la première face S1

Le procédé comprend une étape de formation, dans le substrat SB, d'au moins un via non traversant supraconducteur VS ou (exclusif) d'au moins un via non traversant conducteur VC non supraconducteur, le ou les vias VS ou VC comprenant une extrémité exposée au niveau de la première face (ce ou ces vias seront rendus traversant par la suite).

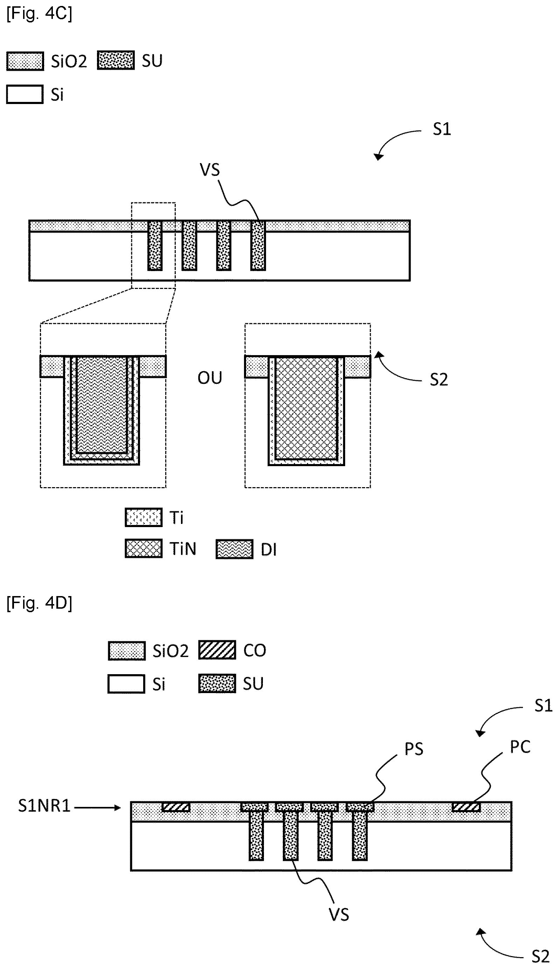

Dans un mode de réalisation, comme illustré aux [Fig. 4B] et [Fig. 4C], le via ou les vias sont des vias supraconducteurs VS et cette étape comprend une sous-étape de gravure d'au moins une tranchée (de préférence une pluralité de tranchées, une tranchée pour chaque via - une tranchée peut avoir une section rectangulaire, ellipsoïdale ou ronde selon un plan parallèle à la surface du substrat SB) au niveau de la première face S1 du substrat SB et sur une partie seulement de l'épaisseur du substrat SB. Dans l'exemple de la [Fig. 4B], la totalité de l'épaisseur de la couche d'oxyde de silicium et une partie de l'épaisseur de la couche de silicium a été gravée.

Elle comprend également une sous-étape de dépôt du ou des matériaux formant le via supraconducteur. Les sous-étapes sont identiques dans le cas où les vias formés sont des vias conducteurs VC non supraconducteurs.

Dans l'exemple de la [Fig. 4C], dans une première variante de réalisation, cette sous-étape comprend tout d'abord le dépôt conforme d'une couche de titane (par exemple par CVD, PVD ou ALD) suivi du dépôt d'une couche de nitrure de titane (par exemple par CVD, PVD ou ALD), l'épaisseur de la couche de nitrure de titane étant choisie de sorte à combler complètement la tranchée gravée lors de la sous-étape précédente. Dans un mode de réalisation, la couche de titane a une épaisseur comprise entre 5 et 20 nm.

Dans l'exemple de la [Fig. 4C], dans une deuxième variante de réalisation, cette sous-étape comprend tout d'abord le dépôt conforme d'une couche de titane (par exemple par CVD, PVD ou ALD) puis d'une couche de nitrure de titane (par exemple par CVD, PVD ou ALD) suivi du dépôt d'une couche d'un matériau diélectrique, l'épaisseur de la couche de matériau diélectrique étant choisie de sorte à combler complètement la tranchée gravée lors de la sous-étape précédente. Dans un mode de réalisation, la couche de titane a une épaisseur comprise entre 5 et 20 nm et la couche de nitrure de titane a une épaisseur comprise entre 5 et 20 nm.

### Formation d'au moins un niveau de routage au niveau de la première face

Comme illustré à la [Fig. 4D], le procédé comprend également une étape de formation d'au moins un niveau de routage S1NR1, de préférence une pluralité de niveaux de routage, au niveau de la première face S1, le niveau de routage S1NR1 comprenant au moins une piste conductrice PC non supraconductrice reliée (si ce dernier a été formé à l'étape précédente) ou destinée à être reliée à un via conducteur et au moins une piste supraconductrice PS reliée (si ce dernier a été formé à l'étape précédente) ou destinée à être reliée à un via supraconducteur VS.

Plus particulièrement, si un seul niveau de routage est présent, alors ce niveau de routage comporte au moins une piste conductrice PC non supraconductrice et une piste supraconductrice PS. En revanche, si plusieurs niveaux de routage sont présents au niveau de la première face S1, alors un niveau de routage donné peut ne comporter qu'une ou plusieurs pistes conductrices PC non supraconductrices ou une ou plusieurs pistes supraconductrices PS.

### Formation des métallisations sous billes sur la première face S1

Dans un mode de réalisation, le procédé comprend également une étape de formation des métallisations sous billes conductrices UBMC au niveau d'au moins une partie des pistes conductrices PC et des métallisations sous billes supraconductrices UBMS au niveau d'une partie au moins des pistes supraconductrices PS.

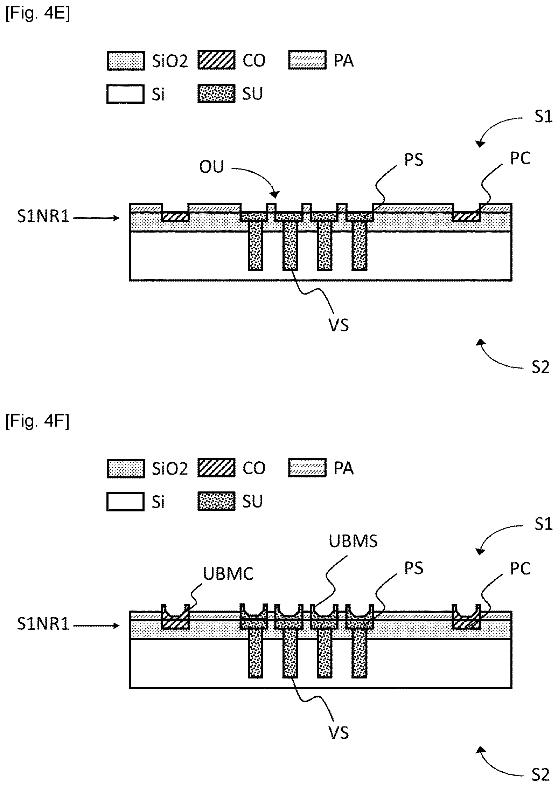

Dans un mode de réalisation illustré aux [Fig. 4E] et [Fig. 4F], cette étape comprend tout d'abord une sous-étape de dépôt d'une couche de passivation PA suivie d'une sous-étape de gravure de la couche de passivation PA de sorte à former des ouvertures OU destinées à recevoir la métallisation sous billes UBMC/UBMS. Cette étape comprend ensuite la réalisation, dans les ouvertures OU obtenues lors de la sous-étape précédente, de la ou des métallisations sous billes conductrices UBMC non supraconductrices au niveau d'une partie au moins des pistes conductrices PC non supraconductrices et de la ou des métallisations sous billes supraconductrices UBMS au niveau d'une partie au moins des pistes de routages supraconductrices PS. Bien entendu, ces sous-étapes sont répétées pour chaque type de métallisations sous billes, autrement dit une première fois pour les métallisations sous billes conductrices UBMC ou supraconductrices UBMS et une deuxième fois pour les métallisations sous billes supraconductrices UBMS ou conductrices UBMC.

### Formation des billes conductrices BIC ou supraconductrices BIS sur la première face S1

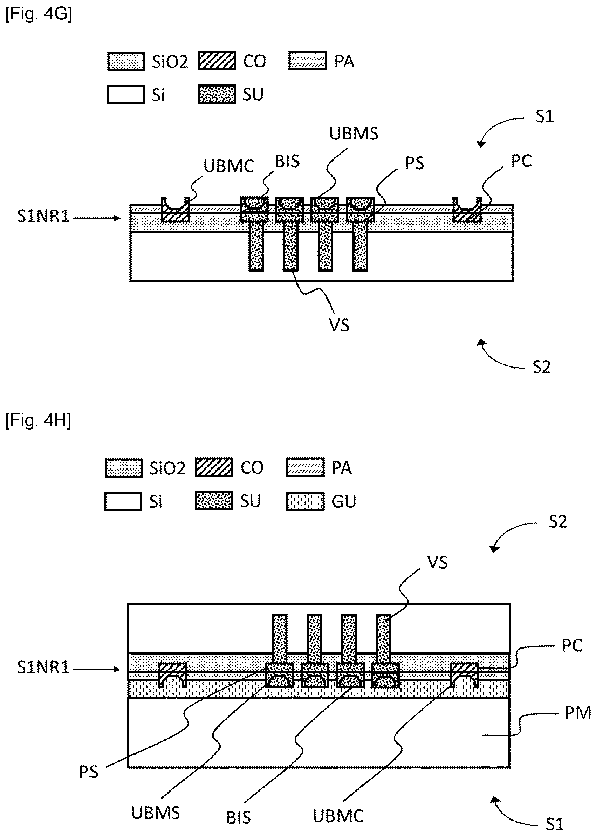

Dans un mode de réalisation, comme illustré à la [Fig. 4G], le procédé comprend également une étape de formation des billes d'un type choisi parmi les billes supraconductrices BIS et les billes conductrices BIC non supraconductrices, les billes BIC/BIS d'un type donné étant formées au niveau des métallisations sous billes UBMC/UBMS du même type. Autrement dit, un seul type de billes BIC/BIS est déposé lors de cette étape. Dans l'exemple de la [Fig. 4G], seules les billes supraconductrices BS sont déposées lors de cette étape, ces dernières étant déposées au niveau des métallisations sous billes supraconductrices UBMS.

### Formation de plots pour collage direct sur la première face S1

Dans un mode de réalisation alternatif, les métallisations sous billes UBMS/UBMC et les billes conductrices BIC non supraconductrices ou les billes supraconductrices BIS au niveau de la première face S1 sont remplacées par des plots permettant une connexion par collage direct. Plus particulièrement, le procédé comprend, après l'étape de formation d'au moins un niveau de routage de la première face :
- Une étape de formation, au niveau de la première face, de plots conducteurs non supraconducteurs au niveau d'une partie au moins des pistes conductrices non supraconductrice, chaque plot conducteur non supraconducteur comprenant de préférence une couche conductrice en contact avec une piste conductrice non supraconductrice et une couche supraconductrice sur la couche conductrice ;
- Une étape de formation, au niveau de la première face, de plots supraconducteurs au niveau d'une partie au moins des pistes supraconductrices, chaque plot supraconducteur comprenant de préférence une couche supraconductrice.

Les avantages techniques de cette solution ont déjà été détaillés précédemment et ne sont donc pas répétés ici.

### Collage temporaire

Comme illustré à la [Fig. 4H], le procédé comprend également une étape de collage temporaire du substrat SB à une poignée de manipulation PM au niveau de sa première face S1. Dans l'exemple de la [Fig. 4H], ce collage est réalisé à l'aide d'une couche d'adhésif GU, par exemple une colle, déposée au niveau de la première face S1 et permettant de coller le substrat SB à la poignée de manipulation PM, ici en silicium.

### Amincissement

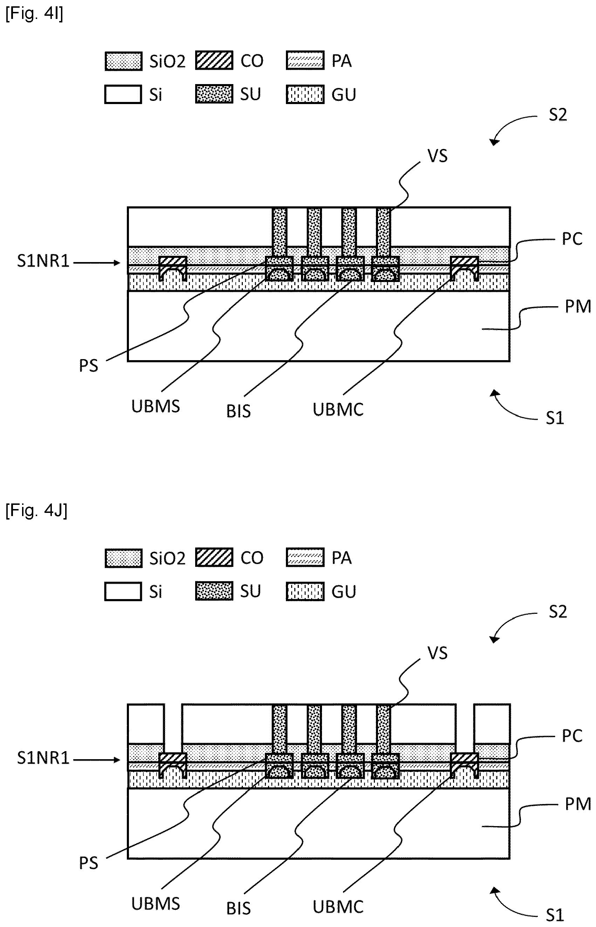

Comme illustré à la [Fig. 4I], le procédé comprend également une étape d'amincissement du substrat SB au niveau de sa deuxième face S2 de sorte à exposer les via supraconducteurs VS les rendant traversants, par exemple par polissage mécano-chimique. Ainsi exposés, les vias VS peuvent ensuite être connectés à un ou plusieurs niveaux de routage.

### Formation d'au moins un via traversant conducteur VC ou supraconducteur VS

Le procédé comprend ensuite une étape de formation, dans le substrat SB, d'au moins un via traversant conducteur VC non supraconducteur si le ou les via formés précédemment sont des vias supraconducteurs VS ou d'au moins un via traversant supraconducteur VS si les vias formés précédemment sont des vias conducteurs VC non supraconducteurs, le ou les vias ainsi formés comprenant une extrémité exposée au niveau de la première face S1 et en contact avec au moins une piste conductrice PC de cette première face S1 dans le cas de vias conducteurs VC ou au moins une piste supraconductrice PS de cette première face S1 dans le cas de vias supraconducteurs VS, et une extrémité exposée au niveau de la deuxième face S2.

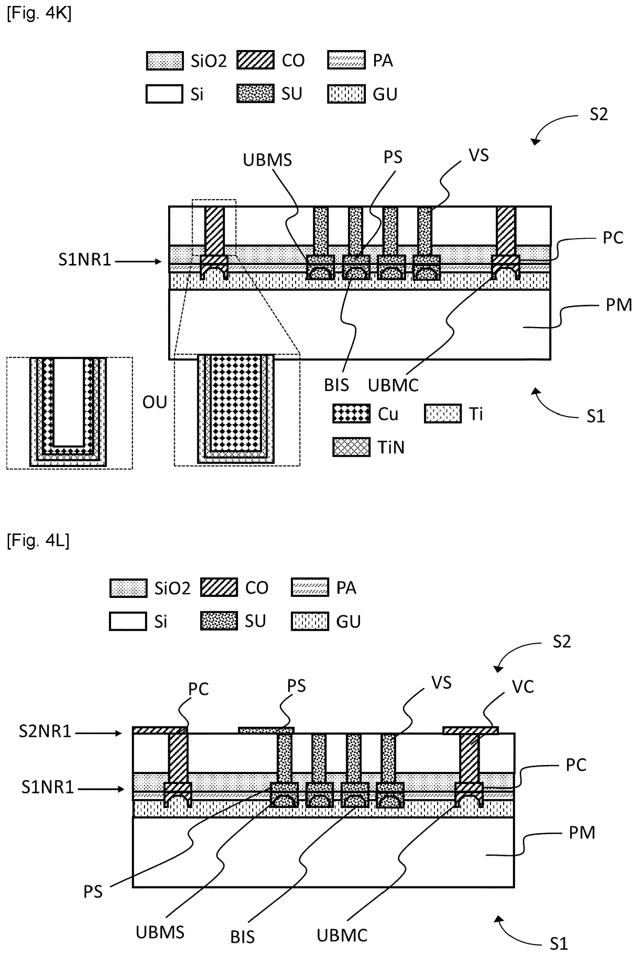

Dans un mode de réalisation illustré aux [Fig. 4J] et [Fig. 4K], le ou les vias sont des vias conducteurs VC non supraconducteurs (des vias supraconducteurs VS ayant été formés précédemment) et cette étape comprend une sous-étape de gravure d'au moins une tranchée (de préférence une pluralité de tranchées, une tranchée pour chaque via) au niveau de la deuxième face S2 du substrat SB et sur la totalité de l'épaisseur du substrat SB jusqu'à atteindre une piste de routage du même type de la première face S1.

Elle comprend également une sous-étape de dépôt du ou des matériaux formant le via conducteur VC non supraconducteur. Les sous-étapes sont identiques dans le cas où les vias formés sont de vias supraconducteurs VS.

Dans un exemple illustré à la [Fig. 4K], cette sous-étape comprend tout d'abord le dépôt conforme d'une couche de titane (par exemple par CVD, PVD ou ALD), puis d'une couche de nitrure de titane (par exemple par CVD, PVD ou ALD), suivi du dépôt d'une couche de cuivre (par exemple, par un dépôt PVD puis ECD), l'épaisseur de la couche de cuivre étant choisie de sorte à combler, partiellement ou complètement, la tranchée gravée lors de la sous-étape précédente. Lorsque la tranchée n'est comblée que partiellement par la couche de cuivre, alors l'épaisseur de la couche de cuivre est de préférence supérieure ou égale à 500 nm de sorte à induire par effet de proximité l'état conducteur dans les couches supraconductrices du via. L'un des avantages de ce procédé selon un troisième aspect de l'invention réside dans la réalisation des vias conducteurs VC non supraconducteurs en fin de procédé, ce qui permet de réaliser des vias conducteurs VC non supraconducteur plus larges qui peuvent être remplis par électrolyse (ECD) (même pour les couches de titane et de nitrure de titane). On notera ici que l'épaisseur de cuivre étant largement supérieure à l'épaisseur de nitrure de titane ou de titane, le cuivre et l'ensemble du via restent conducteurs (et non supraconducteurs) même à très basses températures.

### Formation d'au moins un niveau de routage au niveau de la deuxième face S2

Comme illustré à la [Fig. 4L], le procédé comprend également une étape de formation d'au moins un niveau de routage S2NR1 au niveau de la deuxième face S2, le niveau de routage comprenant au moins une piste conductrice PC non supraconductrice reliée à un via conducteur VC non supraconducteur et au moins une piste supraconductrice PS reliée à un via supraconducteur VS.

Plus particulièrement, si un seul niveau de routage est présent, alors ce niveau de routage comporte au moins une piste conductrice PC non supraconductrice et au moins une piste supraconductrice PS. En revanche, si plusieurs niveaux de routage sont présents au niveau de la deuxième face S2, alors un niveau de routage donné peut ne comporter qu'une ou plusieurs pistes conductrices PC non supraconductrices ou une ou plusieurs pistes supraconductrices PS.

### Formation des métallisations sous billes sur la deuxième face S2

Dans un mode de réalisation, le procédé comprend ensuite une étape de formation, au niveau de la deuxième face S2, des métallisations sous billes conductrices UBMC au niveau d'une partie au moins des pistes conductrices PC et des métallisations sous billes supraconductrices UBMS au niveau d'une partie au moins des pistes supraconductrices PS.

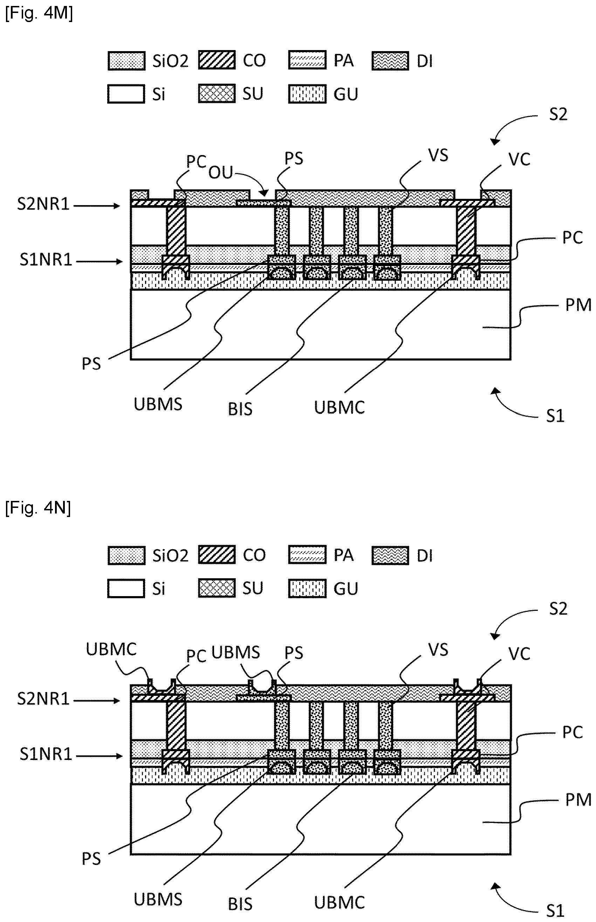

Dans un mode de réalisation illustré aux [Fig. 4M] et [Fig. 4N], cette étape comprend une sous-étape de dépôt d'une couche d'un matériau diélectrique DI, suivie d'une sous-étape de gravure de ladite couche DI de sorte à aménager des ouvertures OU destinées à recevoir la métallisation sous billes UBMS/UBMC. Cette étape comprend ensuite la réalisation, dans les ouvertures OU obtenues lors de la sous-étape précédente, de la ou des métallisations sous billes conductrices UBMC non supraconductrices au niveau d'une partie au moins des pistes conductrices PC non supraconductrices et de la ou des métallisations sous billes supraconductrices UBMS au niveau d'une partie au moins des pistes de routages supraconductrices PS. Bien entendu, ces sous-étapes sont répétées pour chaque type de métallisations sous billes, autrement dit une première fois pour les métallisations sous billes conductrices UBMC ou supraconductrices UBMS et une deuxième fois pour les métallisations sous billes supraconductrices UBMS ou conductrices UBMC.

### Formation des billes conductrices ou supraconductrices sur la deuxième face S2

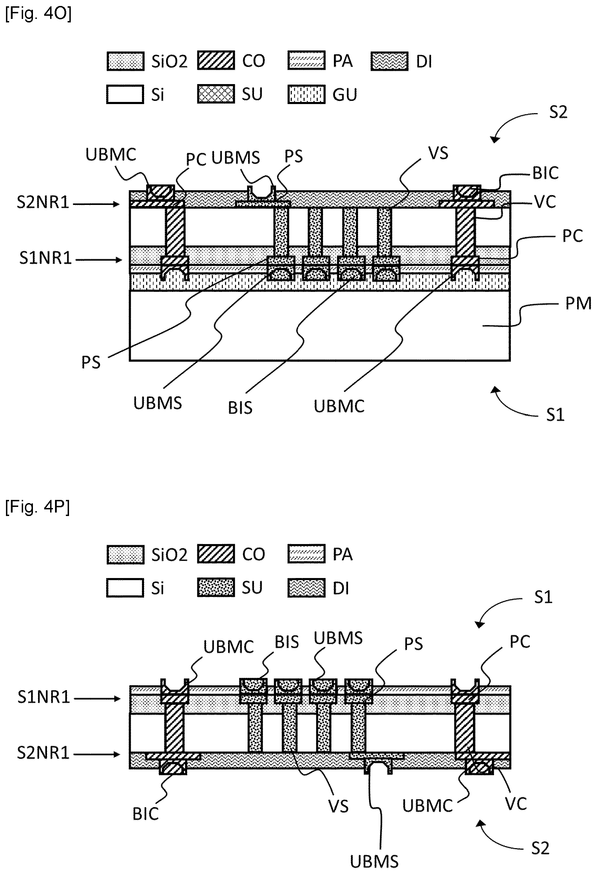

Dans un mode de réalisation, comme illustré à la figure [Fig. 4O], le procédé comprend également une étape de formation des billes BIC/BIS d'un type choisi parmi les billes supraconductrices BIS et les billes conductrices BIC non supraconductrices, les billes BIC/BIS d'un type donné étant formées au niveau des métallisations sous billes UBMC/UBMS du même type au niveau de la deuxième face S2.

Dans l'exemple de la [Fig. 4O], seules les billes conductrices BIC non supraconductrices sont déposées lors de cette étape, ces dernières BIC étant déposées au niveau des métallisations sous billes conductrices UBMC non supraconductrices.

### Formation de plots pour collage direct sur la deuxième face S2

Dans un mode de réalisation alternatif, les métallisations sous billes UBMS/UBMC et les billes conductrices BIC non supraconductrices ou les billes supraconductrices BIS au niveau de la deuxième face S2 sont remplacées par des plots permettant une connexion par collage direct. Plus particulièrement, le procédé comprend, après l'étape de formation d'au moins un niveau de routage au niveau de la deuxième face :
- une étape de formation, au niveau de la deuxième face, de plots conducteurs non supraconducteurs au niveau d'une partie au moins des pistes conductrices non supraconductrices, chaque plot conducteur non supraconducteur comprenant de préférence une couche conductrice en contact avec une piste conductrice non supraconductrice et une couche supraconductrice sur la couche conductrice ;
- une étape de formation, au niveau de la deuxième face, de plots supraconducteurs au niveau d'une partie au moins des pistes supraconductrices, chaque plot supraconducteur comprenant de préférence une couche supraconductrice.

Les avantages techniques de cette solution ont déjà été détaillés précédemment et ne sont donc pas répétés ici.

### Retrait de la poignée de manipulation

Comme illustré à la [Fig. 4P], le procédé comprend enfin une étape de retrait de la poignée de manipulation PM.

### Résultat

A l'issue du procédé, une structure SI d'intégration selon le premier aspect de l'invention est obtenue.

### Troisième procédé de fabrication

Un autre aspect de l'invention concerne un procédé de fabrication d'une structure d'intégration SI à partir d'un substrat SB comprenant une première face S1 et une deuxième face S2. Dans un mode de réalisation, le substrat SB est un substrat de silicium comportant une couche d'oxyde de silicium au niveau de la première face.

### Formation simultanée d'au moins un via non traversant supraconducteur et d'un via non traversant conducteur

Le procédé selon cet aspect comprend une étape de formation simultanée d'au moins un via non traversant supraconducteur VS et d'un via non traversant conducteur VC non supraconducteur.

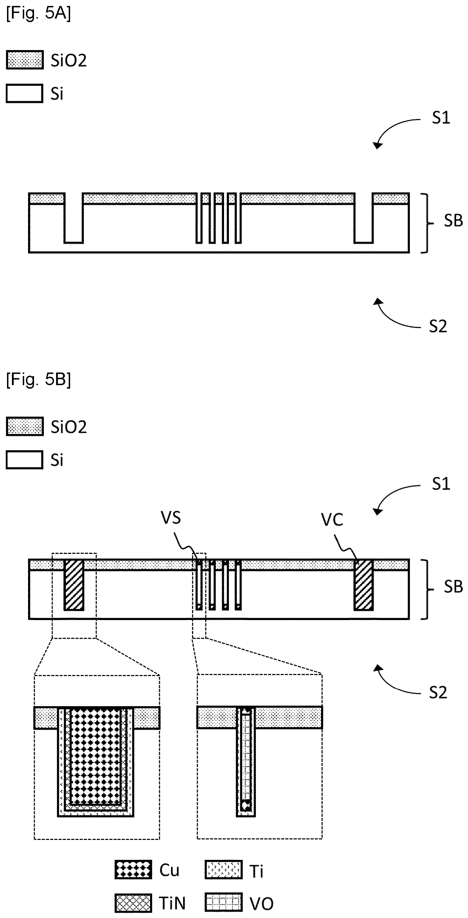

Dans un mode de réalisation illustré à la [Fig. 5A] et [Fig. 5B], cette étape comprend une sous-étape de formation d'une première pluralité de trous cylindriques (ou de tranchées - mode de réalisation non représenté) et d'une deuxième pluralité de trous cylindriques (ou de tranchées), les trous cylindriques (ou les tranchées) de la première pluralité ayant un diamètre (ou une largeur pour les tranchées) compris entre 10 et 100 µm et une hauteur (ou profondeur) comprise entre 100 et 200 µm et les trous cylindriques (ou les tranchées) de la deuxième pluralité ayant un diamètre (ou une largeur pour les tranchées) compris entre 0.5 et 5 µm et une hauteur (ou profondeur) comprise entre 50 et 200 µm (et de préférence identique à celle des trous cylindriques de la première pluralité de trous cylindriques). Dans un mode de réalisation, lorsqu'une première et un deuxième pluralité de tranchées est formée lors de cette sous-étape, alors la longueur de ces tranchées est comprise entre une fois la largeur et cinquante fois la largeur desdites tranchées.

Cette étape comprend ensuite une sous-étape de dépôt conforme d'une couche de titane (par exemple par CVD ou PVD) suivie d'une sous-étape de dépôt conforme d'une couche de nitrure de titane (par exemple par CVD). Dans un mode de réalisation, la couche de titane déposée a une épaisseur comprise entre 5 et 20 nm. Dans un mode de réalisation, la couche de nitrure de titane a une épaisseur compris entre 5 et 50 nm.

Cette étape comprend enfin une sous-étape de dépôt d'une couche de cuivre, ce dépôt se faisant en deux phases, une première phase de dépôt par technique PVD et une deuxième phase de dépôt par technique ECD. Durant la première phase, une couche de cuivre va venir se former au fond des trous formés lors de la gravure. Dans le cas de la deuxième pluralité de trous cylindriques (ou de tranchées), compte tenu du faible diamètre des trous (ou de la faible largeur des tranchées), un bouchon de cuivre va également se former à l'entrée de chaque trou (ou tranchée) de sorte à obstruer ce dernier (ou ces dernières). Durant la deuxième phase, les trous cylindriques (ou les tranchées) de la première pluralité vont ensuite se remplir de cuivre tandis que les trous cylindriques (ou les tranchées) de la deuxième pluralité de trous cylindriques vont demeurer vides en leur centre. Ainsi, lors d'une même sous-étape de dépôt, la première pluralité de trous cylindriques permet d'obtenir des vias conducteurs VC non supraconducteurs tandis que la deuxième pluralité de trous cylindriques permet d'obtenir des vias supraconducteurs VS. Ainsi, comme déjà mentionné, pour les vias conducteurs VC non supraconducteurs, le diamètre du cylindre en cuivre (ou l'épaisseur de la couche de cuivre dans le cas de tranchées) est suffisant pour annuler, par effet de proximité, les propriétés supraconductrices du nitrure de titane. En revanche, en l'absence de cylindre de cuivre (ou de couche de cuivre) pour les vias supraconducteurs VS, le nitrure de titane demeure supraconducteur.

Les étapes du procédé sont ensuite identiques aux étapes du procédé selon un deuxième aspect de l'invention à l'issue de la formation des vias conducteurs VC et supraconducteurs VS. Aussi, ce procédé peut être considéré comme une variante du procédé selon un premier aspect de l'invention.

### Assemblage selon l'invention

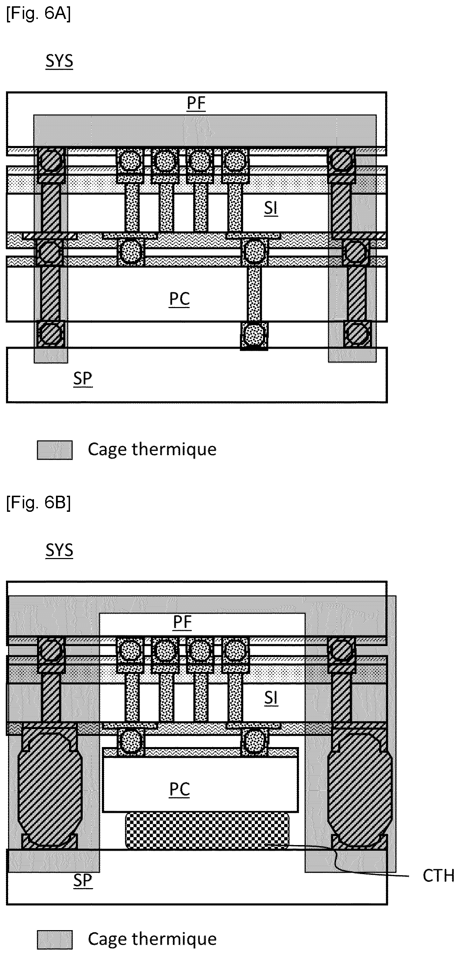

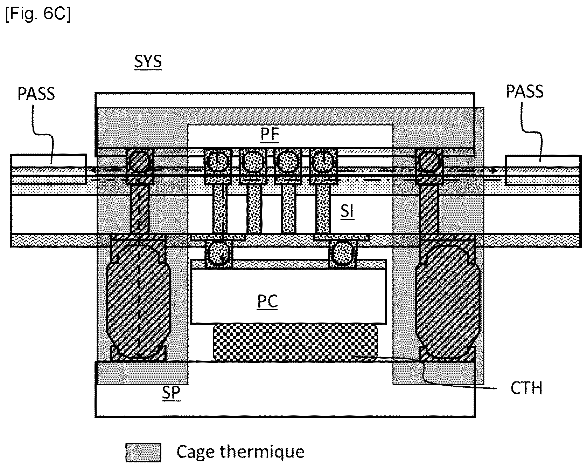

Un quatrième aspect de l'invention illustré aux [Fig. 6A] à [Fig. 6C] concerne un assemblage comprenant une structure d'intégration SI selon un premier aspect de l'invention, un premier dispositif semi-conducteur DS, dit puce fonctionnelle PF et un deuxième dispositif semi-conducteur, dit puce de contrôle PC, la puce fonctionnelle PF étant connectée à la structure d'intégration SI au niveau de la première face S1 et la puce de contrôle étant connectée à la structure d'intégration au niveau de la deuxième face S2.

Dans un mode de réalisation illustré aux [Fig. 6A] à [Fig. 6C], la puce fonctionnelle PF et/ou la puce de contrôle PC comportent des métallisations sous billes conductrices et des métallisations sous billes supraconductrices, les métallisations sous billes conductrices de la puce fonctionnelle PF et/ou de la puce de contrôle PC étant connectées aux métallisations sous billes conductrices UBMC de la structure d'intégration SI à l'aide de billes conductrices BIC non supraconctrices et les métallisations sous billes supraconductrices UBMS de la puce fonctionnelle PF et/ou de la puce de contrôle PC étant connectées aux métallisations sous billes supraconductrices UBMS de la structure d'intégration SI à l'aide de billes supraconductrices BIS. Ainsi, une cage thermique (en grisée sur les figures) est formée à partir des vias conducteurs VC, des pistes conductrices PC, des métallisations sous billes UBMC et des billes conductrices BIC entourant la structure d'intégration SI, la puce fonctionnelle PF et la puce de contrôle PC.

Dans un mode de réalisation alternatif non représenté, la puce fonctionnelle PF et/ou la puce de contrôle PC comportent des plots conducteurs non supraconducteurs et des plots supraconducteurs, les plots conducteurs non supraconducteurs de la puce fonctionnelle PF et/ou de la puce de contrôle PC étant connectés aux plots conducteurs non supraconducteurs de la structure d'intégration SI par collage direct de sorte à former des premiers moyens de connexion et les plots supraconducteurs de la puce fonctionnelle PF et/ou de la puce de contrôle PC étant connectés aux plots supraconducteurs de la structure d'intégration SI par collage direct de sorte à former des deuxièmes moyens de connexion. Dans un mode de réalisation, chaque premier moyen de connexion comprend une première couche d'un matériau conducteur non supraconducteur, une deuxième couche d'un matériau supraconducteur et une troisième couche d'un matériau conducteur non supraconducteur, le collage se faisant au niveau de la couche de matériau supraconducteur. Dans ce même mode de réalisation, les deuxièmes moyens de connexion sont entièrement supraconducteurs. Pour les moyens de connexion, le terme « d'un matériau conducteur » ou « d'un matériau supraconducteur » pourra désigner ici une pluralité de couches d'un même matériau qui, après collage, ne forme qu'une couche unique de ce matériau.

Dans un mode de réalisation, le substrat SB de la structure d'intégration SI est un substrat en silicium ce qui permet d'améliorer l'isolation thermique de la puce fonctionnelle PF par rapport à la puce de contrôle PC car le Si devient isolant thermiquement aux très basses températures nécessaires au fonctionnement des puces fonctionnelles PF.

### Système selon l'invention

Un cinquième aspect de l'invention concerne un système SYS comprenant un support de packaging SP et un assemblage selon un quatrième aspect de l'invention connecté électriquement au support de packaging SP. Dans un mode de réalisation, le support de packaging est un support de type « *ball grid array* » ou bien encore « *land grid array ».*

Dans un mode de réalisation illustré à la [Fig. 6A], la puce de contrôle comprend une première face et une deuxième face et l'assemblage est connecté au support de packaging SP par l'intermédiaire de la deuxième face de la puce de contrôle PC.

Dans un mode de réalisation alternatif illustré à la [Fig. 6B] et à la [Fig. 6C], l'assemblage est connecté au support de packaging SP par l'intermédiaire de la deuxième face S2 de la structure d'intégration SI. Dans ce mode de réalisation alternatif, la puce de contrôle PC est connectée par sa première face à la deuxième face de la structure d'intégration SI et est connectée électriquement par sa deuxième face au support de packaging SP. Dans un mode de réalisation, la connexion mécanique entre le support de packaging SP et la puce de contrôle PC est assurée par une colle thermique CTH permettant l'évacuation de la chaleur générée par la puce de contrôle PC directement vers le support de packaging SP.

Dans un mode de réalisation illustré à la [Fig. 6C], la structure d'intégration SI comporte des éléments passifs PASS, les éléments passifs PASS étant situés à l'extérieur de la cage thermique formée par les connexions conductrices non supraconductrices (comprenant les pistes conductrices PC et les vias conducteurs VC) de l'assemblage AS selon l'invention. Dans un mode de réalisation, les éléments passifs sont choisis parmi une inductance (de préférence supraconductrice), une capacité (de préférence supraconductrice), un résonateur (de préférence supraconductrice) et une résistance (de préférence conducteur non supra). Dans un mode de réalisation, les éléments passifs sont formés dans un ou plusieurs niveaux de routage au niveau de la première face S1 et/ou de la deuxième face S2 de la structure d'intégration SI, à l'aide d'une ou plusieurs pistes de routage, de préférence supraconductrices pour la ou les inductances, la ou les capacitances et/ou la ou les résonateurs. Dans un mode de réalisation, au moins une partie de ces éléments passif PASS est connectée par une liaison supraconductrice à la puce fonctionnelle PF et/ou à la puce de contrôle PC. Dans un mode de réalisation, au moins une partie de ces éléments passifs PASS est connectée par une liaison conductrice non supraconductrice au support de packaging SP. Dans un mode de réalisation la ou les inductances et/ou la ou les capacitances et/ou le ou les résonateurs sont connectés électriquement, à l'aide d'une ou plusieurs pistes de routage, de préférence supraconductrice, à la puce de contrôle PC et/ou à la puce fonctionnelle PF. Dans un mode de réalisation, la ou les résistances sont connectées électriquement par une liaison conductrice non supraconductrice au support de packaging SP.

## Revendications

1. Structure (SI) d'intégration destinée à connecter une pluralité de dispositifs semi-conducteurs (DS), la structure d'intégration comprenant un substrat (SB), une première face (S1) et une deuxième face (S2) destinées à recevoir les dispositifs semi-conducteurs (DS), la structure (SI) d'intégration comprenant, au niveau de la première face (S1), au moins un niveau (S1NR1) de routage, le ou les niveaux (S1NR1) de routage comprenant :
- au moins une piste de routage conductrice (PC) non supraconductrice dans un matériau conducteur non supraconducteur ; et
- au moins une piste de routage supraconductrice (PS) dans un matériau supraconducteur ;
**caractérisé en ce que** la structure (SI) d'intégration comprend, au niveau de la deuxième face (S2), au moins un niveau de routage (S2NR1), le ou les niveaux de routage (S2NR1) comprenant :
- au moins une piste de routage conductrice (PC) non supraconductrice dans un matériau conducteur non supraconducteur ; et
- au moins une piste de routage supraconductrice (PS) dans un matériau supraconducteur ; et
**en ce que** la structure (SI) d'intégration comprend au moins un via conducteur (VC) non supraconducteur reliant une piste de routage conductrice (PC) non supraconductrice de la première face (S1) à une piste conductrice (PC) non supraconductrice de la deuxième face (S2) et au moins un via supraconducteur (VS) reliant une piste de routage supraconductrice (PS) de la première face (S1) à une piste supraconductrice (PS) de la deuxième face (S2).

2. Structure (SI) d'intégration selon la revendication précédente comprenant une pluralité de niveaux de routage au niveau de la première face (S1) et/ou de la deuxième face (S2), les niveaux de routage de la pluralité de niveaux de routage étant connectés, entre pistes de routage de même type, au moyen de vias inter-niveaux (VIS/VIC) de même type.

3. Structure (SI) d'intégration selon la revendication précédente dans laquelle le niveau de routage (S1NR1/S2NR1) le plus proche de la première face (S1) et/ou de la deuxième face (S2) ne comprend qu'une ou plusieurs pistes de routage supraconductrices (PS).

4. Structure d'intégration (SI) selon l'une des revendications précédentes comprenant, sur la première face (S1) et/ou sur la deuxième face (S2), au moins un composant passif.

5. Procédé de fabrication d'une structure d'intégration (SI) à partir d'un substrat (SB) comprenant une première face (S1) et une deuxième face (S2), le procédé comprenant :
- une étape de formation, dans le substrat (SB), d'au moins un via non traversant conducteur (VC) non supraconducteur et d'au moins un via non traversant supraconducteur (VS), les vias (VC/VS) comprenant une extrémité exposée au niveau de la première face (S1) ;
- une étape de formation d'au moins un niveau de routage (S1NR1) au niveau de la première face (S1), le niveau de routage (S1NR1) comprenant au moins une piste conductrice (PC) non supraconductrice reliée à un via conducteur (VC) non supraconducteur et au moins une piste supraconductrice (PS) reliée à un via supraconducteur (VS) ;
- une étape de collage temporaire du substrat (SB) à une poignée de manipulation (PM) au niveau de sa première face (S1) ;
- une étape d'amincissement du substrat (SB) au niveau de sa deuxième face (S2) de sorte à exposer les vias conducteurs (VC) non supraconducteurs et les vias supraconducteurs (VS) les rendant traversants ;
- une étape de formation d'au moins un niveau de routage (S2NR1) au niveau de la deuxième face (S2), le niveau de routage (S2NR1) comprenant au moins une piste conductrice (PC) non supraconductrice reliée à un via conducteur (VC) non supraconducteur et au moins une piste supraconductrice (PS) reliée à un via supraconducteur (VS) ;
- une étape de retrait de la poignée de manipulation (PM).

6. Procédé selon la revendication précédente dans lequel l'étape de formation, dans le substrat (SB), d'au moins un via non traversant conducteur (VC) non supraconducteur et d'au moins un via non traversant supraconducteur (VS) comprend :
- une étape de formation, dans le substrat (SB), d'au moins un via non traversant conducteur (VC) non supraconducteur, le ou les vias (VC) comprenant une extrémité exposée au niveau de la première face (S1) ;
- une étape de formation, dans le substrat (SB), d'au moins un via non traversant supraconducteur (VS), le ou les vias (VS) comprenant une extrémité exposée au niveau de la première face (S1).

7. Procédé selon la revendication 5 dans lequel, lors de l'étape de formation d'au moins un via non traversant conducteur (VC) non supraconducteur et d'au moins un via non traversant supraconducteur (VS), les deux types de vias sont formés simultanément.

8. Procédé de fabrication d'une structure d'intégration (SI) à partir d'un substrat (SB) comprenant une première face (S1) et une deuxième face (S2) et comprenant :
- une étape de formation, dans le substrat (SB), d'au moins un via non traversant supraconducteur (VS) ou d'au moins un via non traversant conducteur (VC) non supraconducteur, le ou les vias (VS/VC) comprenant une extrémité exposée au niveau de la première face (S1) ;
- une étape de formation d'au moins un niveau de routage (S1NR1) au niveau de la première face (S1), le niveau de routage (S1NR1) comprenant au moins une piste conductrice (PC) non supraconductrice reliée à un via conducteur (VC) lorsqu'un tel via a été formé lors de l'étape précédente et au moins une piste supraconductrice reliée à un via supraconducteur (VS) lorsqu'un tel via a été formé lors de l'étape précédente ;
- une étape de collage temporaire du substrat (SB) à une poignée de manipulation (PM) au niveau de sa première face (S1) ;
- une étape d'amincissement du substrat (SB) au niveau de sa deuxième face (S2) de sorte à exposer les vias traversants conducteurs non supraconducteurs ou les vias traversants supraconducteurs (VS) formés lors de la première ;
- une étape de formation, dans le substrat (SB) au niveau de la deuxième face (S2), d'au moins un via traversant conducteur (VC) non supraconducteur si au moins un via supraconducteur (VS) a été formé précédemment ou au moins un via traversant supraconducteur (VS) si au moins un via conducteur (VC) non supraconducteur a été formé précédemment, le ou les vias (VC/VS) comprenant une extrémité au niveau de la première face (S1) en contact avec au moins une piste du même type (PC/PS) de cette première face (S1), et une extrémité exposée au niveau de la deuxième face (S2) ;
- une étape de formation d'au moins un niveau de routage (S2NR1) au niveau de la deuxième face (S2), le niveau de routage (S2NR1) comprenant au moins une piste conductrice (PC) non supraconductrice reliée à un via conducteur (VC) non supraconducteur et au moins une piste supraconductrice (PS) reliée à un via supraconducteur (VS) ;
- une étape de retrait de la poignée de manipulation (PM).

9. Procédé selon l'une des revendications 5 à 8 comprenant, après l'étape de formation d'au moins un niveau de routage (S1NR1) au niveau de la première face (S1) :
- une étape de formation, au niveau de la première face (S1), de métallisations sous billes conductrices (UBMC) au niveau d'une partie au moins des pistes conductrices (PC) et de métallisations sous billes supraconductrices (UBMS) au niveau d'une partie au moins des pistes supraconductrices (PS) ;
- une étape de formation de billes d'un type choisi parmi les billes supraconductrices (BIS) et les billes conductrices (BIC) non supraconductrices, les billes (BIS/BIC) d'un type donné étant formées au niveau des métallisations sous billes (UMBS/UBMC) du même type au niveau de la première face (S1).

10. Procédé selon l'une des revendications 5 à 9 comprenant, après l'étape de formation d'au moins un niveau de routage (S2NR1) au niveau de la deuxième face (S2) :
- une étape de formation, au niveau de la deuxième face (S2), de métallisations sous billes conductrices (UBMC) au niveau d'une partie au moins des pistes conductrices (PC) et de métallisations sous billes supraconductrices (UBMS) au niveau d'une partie au moins des pistes supraconductrices (PS) ;
- une étape de formation de billes d'un type choisi parmi les billes supraconductrices (BIS) et les billes conductrices (BIC) non supraconductrices, les billes (BIS/BIC) d'un type donné étant formées au niveau des métallisation sous billes (UBMS/UBMC) du même type au niveau de la deuxième face (S2).

11. Assemblage comprenant une structure d'intégration (SI) selon l'une des revendications 1 à 4, un premier dispositif semi-conducteur, dit puce fonctionnelle (PF) et un deuxième dispositif semi-conducteur, dit puce de contrôle (PC), la puce fonctionnelle (PF) étant connectée à la structure d'intégration (SI) au niveau de la première face (S1) et la puce de contrôle (PC) étant connectée à la structure d'intégration (SI) au niveau de la deuxième face (S2).

12. Système (SYS) comprenant un support de packaging (SP) et un assemblage selon la revendication précédente connecté électriquement au support de packaging (SP).

13. Système (SYS) selon la revendication précédente dans lequel la puce de contrôle (PC) comprend une première face (S1) et une deuxième face (S2) et dans lequel l'assemblage est connecté thermiquement au support de packaging (SP) par l'intermédiaire de la deuxième face (S2) de la puce de contrôle (PC), ladite puce de contrôle (PC) étant connectée électriquement par sa première face (S1) à la deuxième face (S2) de la structure d'intégration (SI).

14. Système (SYS) selon la revendication 12 dans lequel l'assemblage est connecté électriquement au support de packaging (SP) par l'intermédiaire de la deuxième face (S2) de la structure d'intégration (SI).

15. Système (SYS) selon l'une des revendications 12 à 14 comprenant une structure d'intégration (SI) selon la revendication 4 et dans lequel les composant passifs comprennent une inductance et/ou une capacité et/ou une résonateur et/ou une résistance, ladite inductance et/ou ladite capacitance et/ou ledit résonateur étant connectés électriquement, à l'aide d'une ou plusieurs pistes de routage à la puce de contrôle (PC) et/ou à la puce fonctionnelle (PF), et ladite résistance étant connectée par une liaison conductrice non supraconductrice au support de packaging (SP).

## Patentansprüche

1. Integrationsstruktur (SI) zum Verbinden einer Vielzahl von Halbleiterbauelementen (DS), wobei die Integrationsstruktur ein Substrat (SB), eine erste Seite (S1) und eine zweite Seite (S2) zur Aufnahme der Halbleiterbauelemente (DS) umfasst und die Integrationsstruktur (SI) auf der ersten Seite (S1) mindestens eine Verdrahtungsebene (S1NR1) umfasst, wobei die Verdrahtungsebene(n) (S1NR1) Folgendes umfasst/umfassen:
- mindestens eine nicht-supraleitende Leiterbahn (PC) aus einem nicht supraleitenden leitenden Material; und
- mindestens eine supraleitende Leiterbahn (PS) aus einem supraleitenden Material;
**dadurch gekennzeichnet, dass** die Integrationsstruktur (SI) auf der zweiten Seite (S2) mindestens eine Verdrahtungsebene (S2NR1) umfasst, wobei die Verdrahtungsebene(n) (S2NR1) Folgendes umfasst/umfassen:
- mindestens eine nicht-supraleitende Leiterbahn (PC) aus einem nicht-supraleitenden leitenden Material; und
- mindestens eine supraleitende Leiterbahn (PS) aus einem supraleitenden Material; und
dass die Integrationsstruktur (SI) mindestens eine nicht-supraleitende leitende Durchkontaktierung (VC) umfasst, die eine nicht-supraleitende Leiterbahn (PC) der ersten Seite (S1) mit einer nicht-supraleitenden Leiterbahn (PC) der zweiten Seite (S2) verbindet, sowie mindestens eine supraleitende Durchkontaktierung (VS), die eine supraleitende Leiterbahn (PS) der ersten Seite (S1) mit einer supraleitenden Leiterbahn (PS) der zweiten Seite (S2) verbindet.

2. Integrationsstruktur (SI) nach dem vorstehenden Anspruch, die eine Vielzahl von Verdrahtungsebenen auf der ersten Seite (S1) und/oder der zweiten Seite (S2) umfasst, wobei die Verdrahtungsebenen der Vielzahl von Verdrahtungsebenen zwischen Leiterbahnen desselben Typs mittels Durchkontaktierungen (VIS/VIC) zwischen Ebenen desselben Typs verbunden sind.

3. Integrationsstruktur (SI) nach dem vorstehenden Anspruch, in der die der ersten Seite (S1) und/oder der zweiten Seite (S2) am nächsten gelegene Verdrahtungsebene (S1NR1/S2NR1) nur eine oder mehrere supraleitende Leiterbahnen (PS) umfasst.

4. Integrationsstruktur (SI) nach einem der vorstehenden Ansprüche, die auf der ersten Seite (S1) und/oder auf der zweiten Seite (S2) mindestens ein passives Bauelement umfasst.

5. Verfahren zur Herstellung einer Integrationsstruktur (SI) ausgehend von einem Substrat (SB), das eine erste Seite (S1) und eine zweite Seite (S2) umfasst, wobei das Verfahren umfasst:
- einen Schritt zum Bilden mindestens einer nicht durchgehenden, nicht supraleitenden leitenden Durchkontaktierung (VC) und mindestens einer nicht durchgehenden supraleitenden Durchkontaktierung (VS) in dem Substrat (SB), wobei die Durchkontaktierungen (VC/VS) ein auf der ersten Seite (S1) freiliegendes Ende aufweisen;
- einen Schritt zum Bilden mindestens einer Verdrahtungsebene (S1NR1) auf der ersten Seite (S1), wobei die Verdrahtungsebene (S1NR1) mindestens eine nicht-supraleitende Leiterbahn (PC), die mit einer nicht-supraleitenden Durchkontaktierung (VC) verbunden ist, und mindestens eine supraleitende Leiterbahn (PS) umfasst, die mit einer supraleitenden Durchkontaktierung (VS) verbunden ist;
- einen Schritt zum vorübergehenden Verkleben des Substrats (SB) mit einem Handgriff (PM) auf seiner ersten Seite (S1);
- einen Schritt zum Ausdünnen des Substrats (SB) auf seiner zweiten Seite (S2), um die nicht-supraleitenden Durchkontaktierungen (VC) freizulegen und die supraleitenden Durchkontaktierungen (VS) durchgängig zu machen;
- einen Schritt zum Bilden mindestens einer Verdrahtungsebene (S2NR1) auf der zweiten Seite (S2), wobei die Verdrahtungsebene (S2NR1) mindestens eine nicht-supraleitende Leiterbahn (PC) , die mit einer nicht-supraleitenden leitenden Durchkontaktierung (VC) verbunden ist, und mindestens eine supraleitende Leiterbahn (PS) umfasst, die mit einer supraleitenden Durchkontaktierung (VS) verbunden ist;
- einen Schritt zum Entfernen des Handgriffs (PM).

6. Verfahren nach dem vorstehenden Anspruch, bei dem der Schritt des Bildens mindestens einer nicht durchgehenden, nicht supraleitenden leitenden Durchkontaktierung (VC) und mindestens einer nicht durchgehenden, supraleitenden Durchkontaktierung (VS) im Substrat (SB) umfasst:
- einen Schritt zum Bilden mindestens einer nicht durchgehenden, leitenden, nicht supraleitenden Durchkontaktierung (VC) im Substrat (SB), wobei die Durchkontaktierung(en) (VC) ein auf der ersten Seite (S1) freiliegendes Ende aufweist/aufweisen;
- einen Schritt zum Bilden mindestens einer nicht durchgehenden supraleitenden Durchkontaktierung (VS) im Substrat (SB), wobei die Durchkontaktierung(en) (VS) ein auf der ersten Seite (S1) freiliegendes Ende aufweisen.

7. Verfahren nach Anspruch 5, bei dem im Schritt des Bildens mindestens einer nicht durchgehenden, nicht supraleitenden leitenden Durchkontaktierung (VC) und mindestens einer nicht durchgehenden supraleitenden Durchkontaktierung (VS) beide Arten von Durchkontaktierungen gleichzeitig gebildet werden.

8. Verfahren zur Herstellung einer Integrationsstruktur (SI) aus einem Substrat (SB), das eine erste Seite (S1) und eine zweite Seite (S2) aufweist, umfassend:
- einen Schritt zum Bilden mindestens einer supraleitenden, nicht durchgehenden Durchkontaktierung (VS) oder mindestens einer nicht supraleitenden, leitenden, nicht durchgehenden Durchkontaktierung (VC) im Substrat (SB), wobei die Durchkontaktierung(en) (VS/VC) ein auf der ersten Seite (S1) freiliegendes Ende aufweist/aufweisen;
- einen Schritt zum Bilden mindestens einer Verdrahtungsebene (S1 NR1) auf der ersten Seite (S1), wobei die Verdrahtungsebene (S1NR1) mindestens eine nicht-supraleitende Leiterbahn (PC), die mit einer leitenden Durchkontaktierung (VC) verbunden ist, wenn eine solche Durchkontaktierung im vorherigen Schritt gebildet wurde, und mindestens eine supraleitende Leiterbahn umfasst, die mit einer supraleitenden, Durchkontaktierung (VS) verbunden ist, wenn eine solche Durchkontaktierung im vorherigen Schritt gebildet wurde;
- einen Schritt zum vorübergehenden Verkleben des Substrats (SB) mit einem Handgriff (PM) an seiner ersten Seite (S1);
- einen Schritt zum Ausdünnen des Substrats (SB) an seiner zweiten Seite (S2), um die im ersten Schritt gebildeten nicht-supraleitenden leitenden Durchkontaktierungen oder die supraleitenden Durchkontaktierungen (VS) freizulegen;
- einen Schritt zum Bilden mindestens einer nicht-supraleitenden leitenden durchgehenden Durchkontaktierung (VC), wenn zuvor mindestens eine supraleitende Durchkontaktierung (VS) gebildet wurde, oder mindestens einer supraleitenden durchgehenden Durchkontaktierung (VS), wenn zuvor mindestens eine nicht supraleitende leitende Durchkontaktierung (VC) gebildet wurde, wobei die Durchkontaktierung(en) (VC/VS) ein Ende auf der ersten Seite (S1) aufweist (aufweisen), das mit mindestens einer Leiterbahn desselben Typs (PC/PS) dieser ersten Seite (S1) in Kontakt steht, und ein freiliegendes Ende auf der zweiten Seite (S2) aufweist (aufweisen);
- einen Schritt zum Bilden mindestens einer Verdrahtungsebene (S2NR1) auf der zweiten Seite (S2), wobei die Verdrahtungsebene (S2NR1) mindestens eine nicht-supraleitende Leiterbahn (PC), die mit einer nicht-supraleitenden leitenden Durchkontaktierung (VC) verbunden ist, und mindestens eine supraleitende Leiterbahn (PS) umfasst, die mit einer supraleitenden Durchkontaktierung (VS) verbunden ist;
- einen Schritt zum Entfernen des Handgriffs (PM).

9. Verfahren nach einem der Ansprüche 5 bis 8, das nach dem Schritt des Bildens mindestens einer Verdrahtungsebene (S1NR1) auf der ersten Seite (S1) umfasst:
- einen Schritt zum Bilden von Metallisierungen unter leitenden Kugeln (UBMC) auf der ersten Seite (S1) an mindestens einem Teil der leitenden Leiterbahnen (PC) und von Metallisierungen unter supraleitenden Kugeln (UBMS) an mindestens einem Teil der supraleitenden Leiterbahnen (PS);
- einen Schritt zum Bilden von Kugeln eines Typs, der aus supraleitenden Kugeln (BIS) und nicht-supraleitenden leitenden Kugeln (BIC) ausgewählt wird, wobei die Kugeln (BIS/BIC) eines bestimmten Typs auf den Metallisierungen unter Kugeln (UMBS/UBMC) desselben Typs auf der ersten Seite (S1) gebildet werden.

10. Verfahren nach einem der Ansprüche 5 bis 9, das nach dem Schritt des Bildens mindestens einer Verdrahtungsebene (S2NR1) auf der zweiten Seite (S2) umfasst:
- einen Schritt zum Bilden von Metallisierungen unter leitenden Kugeln (UBMC) auf der zweiten Seite (S2) an mindestens einem Teil der leitenden Leiterbahnen (PC) und von Metallisierungen unter supraleitenden Kugeln (UBMS) an mindestens einem Teil der supraleitenden Leiterbahnen (PS);
- einen Schritt zum Bilden von Kugeln eines Typs, der aus supraleitenden Kugeln (BIS) und nicht-supraleitenden leitenden Kugeln (BIC) ausgewählt wird, wobei die Kugeln (BIS/BIC) eines bestimmten Typs auf den Metallisierungen unter Kugeln (UBMS/UBMC) desselben Typs auf der zweiten Seite (S2) gebildet werden.

11. Baugruppe, umfassend eine Integrationsstruktur (SI) nach einem der Ansprüche 1 bis 4, eine erste Halbleitervorrichtung, einen sogenannten Funktionschip (PF), und eine zweite Halbleitervorrichtung, einen sogenannten Steuerchip (PC), wobei der Funktionschip (PF) auf der ersten Seite (S1) mit der Integrationsstruktur (SI) verbunden ist und der Steuerchip (PC) auf der zweiten Seite (S2) mit der Integrationsstruktur (SI) verbunden ist.

12. System (SYS), umfassend einen Verpackungsträger (SP) und eine Baugruppe nach dem vorstehenden Anspruch, die elektrisch mit dem Verpackungsträger (SP) verbunden ist.

13. System (SYS) nach dem vorstehenden Anspruch, bei dem der Steuerchip (PC) eine erste Seite (S1) und eine zweite Seite (S2) umfasst und bei dem die Baugruppe über die zweite Seite (S2) des Steuerchips (PC) thermisch mit dem Verpackungsträger (SP) verbunden ist, wobei der Steuerchip (PC) über seine erste Seite (S1) elektrisch mit der zweiten Seite (S2) der Integrationsstruktur (SI) verbunden ist.

14. System (SYS) nach Anspruch 12, bei dem die Baugruppe über die zweite Seite (S2) der Integrationsstruktur (SI) elektrisch mit dem Verpackungsträger (SP) verbunden ist.

15. System (SYS) nach einem der Ansprüche 12 bis 14, das eine Integrationsstruktur (SI) nach Anspruch 4 umfasst und bei dem die passiven Komponenten eine Induktivität und/oder eine Kapazität und/oder einen Resonator und/oder einen Widerstand umfassen, wobei die Induktivität und/oder die Kapazität und/oder der Resonator mittels einer oder mehrerer Leiterbahnen elektrisch mit dem Steuerchip (PC) und/oder dem Funktionschip (PF) verbunden sind und der Widerstand über eine nicht-supraleitende leitende Verbindung mit dem Verpackungsträger (SP) verbunden ist.

## Claims

1. An integration structure (SI) for connecting a plurality of semiconductor devices (DS), the integration structure comprising a substrate (SB), a first face (S1) and a second face (S2) for receiving the semiconductor devices (DS), the integration structure (SI) comprising, at the first face (S1), at least one routing level (S1NR1), the routing level(s) (S1NR1) comprising:
- at least one non-superconducting conductive routing track (PC) of a non-superconducting conductive material; and
- at least one superconducting routing track (PS) of a superconducting material;
**characterised in that** the integration structure (SI) comprises, at the second face (S2), at least one routing level (S2NR1), the routing level(s) (S2NR1) comprising:
- at least one non-superconducting conductive routing track (PC) of a non-superconducting conductive material; and
- at least one superconducting routing track (PS) of a superconducting material; and
**in that** the integration structure (SI) comprises at least one non-superconducting conductive via (VC) connecting a non-superconducting conductive routing track (PC) of the first face (S1) to a non-superconducting routing track (PC) of the second face (S2) and/or at least one superconducting via (VS) connecting a superconducting routing track (PS) of the first face (S1) to a superconducting track (PS) of the second face (S2).

2. The integration structure (SI) according to the preceding claim, comprising a plurality of routing levels at the first face (S1) and/or the second face (S2), the routing levels of the plurality of routing levels being connected, between routing tracks of the same type, by means of inter-level vias (VIS/VIC) of the same type.

3. The integration structure (SI) according to the preceding claim, wherein the routing level (S1NR1/S2NR1) closest to the first face (S1) and/or the second face (S2) only comprises one or more superconducting routing tracks (PS).

4. The integration structure (SI) according to one of the preceding claims, comprising, on the first face (S1) and/or on the second face (S2), at least one passive component.

5. A method for manufacturing an integration structure (SI) from a substrate (SB) comprising a first face (S1) and a second face (S2), the method comprising:
- a step of forming, in the substrate (SB), at least one non-superconducting conductive non-through via (VC) and at least one superconducting non-through via (VS), the vias (VC/VS) comprising an end exposed at the first face (S1);
- a step of forming at least one routing level (S1NR1) at the first face (S1), the routing level (S1NR1) comprising at least one non-superconducting conductive track (PC) connected to a non-superconducting conductive via (VC) and at least one superconducting track (PS) connected to a superconducting via (VS);
- a step of temporarily bonding the substrate (SB) to a manipulating handle (PM) at its first face (S1);
- a step of thinning the substrate (SB) at its second face (S2) so as to expose the non-superconducting conductive vias (VC) and the superconducting vias (VS) making them through vias;
- a step of forming at least one routing level (S2NR1) at the second face (S2), the routing level (S2NR1) comprising at least one non-superconducting conductive track (PC) connected to a non-superconducting conductive via (VC) and at least one superconducting track (PS) connected to a superconducting via (VS);
- a step of removing the manipulating handle (PM).

6. The method according to the preceding claim wherein the step of forming, in the substrate (SB), at least one non-superconducting conductive non-through via (VC) and at least one superconducting non-through via (VS) comprises:
- a step of forming, in the substrate (SB), at least one non-superconducting conductive non-through via (VC), the via(s) (VC) comprising an end exposed at the first face (S1);
- a step of forming, in the substrate (SB), at least one superconducting non-through via (VS), the via(s) (VS) comprising an end exposed at the first face (S1).

7. The method according to claim 5 wherein, in the step of forming at least one non-superconducting conductive non-through via (VC) and at least one superconducting non-through via (VS), both types of vias are formed simultaneously.

8. The method for manufacturing an integration structure (SI) from a substrate (SB) comprising a first face (S1) and a second face (S2) and comprising:
- a step of forming, in the substrate (SB), at least one superconducting non-through via (VS) or at least one non-superconducting conductive non-through via (VC), the via(s) (VS/VC) comprising an end exposed at the first face (S1);
- a step of forming at least one routing level (S1NR1) at the first face (S1), the routing level (S1NR1) comprising at least one non-superconducting conductive track (PC) connected to a conductive via (VC) when such a via has been formed in the previous step and at least one superconducting track connected to a superconducting via (VS) when such a via has been formed in the previous step;
- a step of temporarily bonding the substrate (SB) to a manipulating handle (PM) at its first face (S1);
- a step of thinning the substrate (SB) at its second face (S2) so as to expose the non-superconducting conductive through vias or the superconducting through vias (VS) formed in the first step; and
- a step of forming, in the substrate (SB) at the second face (S2), at least one non-superconducting conductive through via (VC) if at least one superconducting via (VS) has been previously formed or at least one superconducting through via (VS) if at least one non-superconducting conductive via (VC) has been previously formed, the via(s) (VC/VS) comprising an end at the first face (S1) in contact with at least one track of the same type (PC/PS) of this first face (S1), and an end exposed at the second face (S2);
- a step of forming at least one routing level (S2NR1) at the second face (S2), the routing level (S2NR1) comprising at least one non-superconducting conductive track (PC) connected to a non-superconducting conductive via (VC) and at least one superconducting track (PS) connected to a superconducting via (VS);
- a step of removing the manipulating handle (PM).

9. The method according to one of claims 5 to 8 comprising, after the step of forming at least one routing level (S1NR1) at the first face (S1):
- a step of forming, at the first face (S1), conductive under-bump metallisations (UBMC) at least at part of the conductive tracks (PC) and superconducting under-bump metallisations (UBMS) at least at part of the superconducting tracks (PS);
- a step of forming bumps of a type selected from superconducting bumps (BIS) and non-superconducting conductive bumps (BIC), the bumps (BIS/BIC) of a given type being formed at the under-bump metallisations (UMBS/UBMC) of the same type at the first face (S1).

10. The method according to one of claims 5 to 9 comprising, after the step of forming at least one routing level (S2NR1) at the second face (S2):
- a step of forming, at the second face (S2), conductive under-bump metallisations (UBMC) at least at part of the conductive tracks (PC) and superconducting under-bump metallisations (UBMS) at least at part of the superconducting tracks (PS);
- a step of forming bumps of a type selected from superconducting bumps (BIS) and non-superconducting conductive bumps (BIC), the bumps (BIS/BIC) of a given type being formed at the under-bump metallisations (UBMS/UBMC) of the same type at the second face (S2).

11. An assembly comprising an integration structure (SI) according to one of claims 1 to 4, a first semiconductor device, called functional chip (PF), and a second semiconductor device, called control chip (PC), the functional chip (PF) being connected to the integration structure (SI) at the first face (S1) and the control chip (PC) being connected to the integration structure (SI) at the second face (S2).

12. A system (SYS) comprising a packaging support (SP) and an assembly according to the preceding claim electrically connected to the packaging support (SP).

13. The system (SYS) according to the preceding claim wherein the control chip (PC) comprises a first face and a second face and wherein the assembly is thermally connected to the packaging support (SP) through the second face of the control chip (PC), said control chip (PC) being electrically connected by its first face to the second face (S2) of the integration structure (SI).

14. The system (SYS) according to claim 12 wherein the assembly is electrically connected to the packaging support (SP) through the second face (S2) of the integration structure (SI).

15. The system (SYS) according to one of claims 12 to 14 comprising an integration structure (SI) according to claim 4 and wherein the passive components comprise an inductor and/or a capacitor and/or a resonator and/or a resistor, said inductor and/or capacitor and/or resonator being electrically connected, using one or more routing tracks to the control chip (PC) and/or the functional chip (PF), and said resistor being connected by a non-superconducting conductive link to the packaging support (SP).
